# EUROPEAN PATENT SPECIFICATION

(11) **EP 0 410 695 B1**
(45) Date of publication and mention of the grant of the patent: **24.10.2001**
(21) Application number: 90308094.3
(22) Date of filing: 24.07.1990
(51) Int. Cl.: H01L 27/15, G06K 15/12, G09G 3/32

(54) **Light-emitting device**
Lichtemittierende Vorrichtung
Dispositif émetteur de lumière

(30) Priority: 25.07.1989 JP 19216189; 23.04.1990 JP 10693289
(43) Date of publication of application: 30.01.1991
(73) Proprietor: NIPPON SHEET GLASS CO., LTD., Chuo-ku Osaka (JP)
(72) Inventor: Kusuda, Yukihisa, c/o Nippon Sheet Glass Co., Ltd., Chuo-ku, Osaka (JP); Tone, Kiyoshi, c/o Nippon Sheet Glass Co., Ltd., Chuo-ku, Osaka (JP); Yamashita, Ken, c/o Nippon Sheet Glass Co., Ltd., Chuo-ku, Osaka (JP); Tanaka, Shuhei, c/o Nippon Sheet Glass Co., Ltd., Chuo-ku, Osaka (JP); Ohno, Seiji, c/o Nippon Sheet Glass Co., Ltd., Chuo-ku, Osaka (JP); Kuroda, Yasunao, c/o Nippon Sheet Glass Co., Ltd., Chuo-ku, Osaka (JP); Komaba, Nobuyuki, c/o Nippon Sheet Glass Co., Ltd., Chuo-ku, Osaka (JP)
(74) Representative: Price, Paul Anthony King

(56) References cited:
- EP-A- 0 335 553
- US-A- 3 680 049
- US-A- 3 696 389

## Description

The present invention relates to an improvement in light-emitting devices which can be integrally formed on a single substrate and have a self-scanning function and, more particularly, to a light-emitting device which can reduce bias light and realizes a long life and therefore can be applied to an optical printer or the like.

An LED (Light-Emitting Diode) and an LD (Laser Diode) are known as typical light-emitting elements.

In an LED, a PN or PIN junction of a compound semiconductor (e.g., GaAs, GaP, AlGaAs, InGaAsP, or InGaAlAs) is formed, and a forward voltage is applied to the junction to inject carriers into the junction, thereby causing light emission phenomenon during recombination.

An LD has a structure in which a waveguide is formed inside the LED. When the current is equal to or greater than a threshold value, the number of injected electron-hole pairs is increased to produce an inverted distribution state, and multiplication (gain) of photons is caused by induced radiation or the like. As a result, light generated by parallel reflecting mirrors using a cleavage plane or the like is fed back to an active layer to cause laser oscillation, thereby emitting laser light from the end face of the waveguide.

As a light-emitting element having the same light-emitting mechanism as those of the LED and the LD, a negative resistance element (e.g., a light-emitting thyristor or a laser thyristor) having a light emission function is known. A light-emitting thyristor forms a pnpn structure on a compound semiconductor and is put into practical use as a thyristor in silicon.

A large number of these light-emitting elements, in particular the LEDs, are formed on a compound semiconductor substrate and cut into individual elements, and each cut element is packaged and commercially available as a single light-emitting element. LEDs (light-emitting elements) as a light source for a contact image sensor or a printer are commercially available as an LED array in which a plurality of LEDs are arranged on a single chip.

In applications of a contact image sensor, an LED printer and the like, a read point and a write point are designated in the array. For this reason, a function of scanning a light emission point of the light-emitting element is required.

In order to perform optical scanning by using these conventional light-emitting elements, each LED of an LED array must be connected to a driving IC by a technique such as wire bonding so that the IC drives the LED. Therefore, if the number of LEDs is large, the same large number of wire bondings is required, giving a high manufacturing cost. As a result, a wide space for installing the driving ICs is required, making it difficult to form a compact device. In addition, since the pitch between the ICs is determined by the wire bonding technique, it is difficult to arrange the LEDs with a small pitch.

The present inventors applied a self-scanning function to a light-emitting element array, thereby solving the above problem of a large number of wire bonding operations, a wide installation space for the driving ICs, and the difficulty in realization of a compact device with a small pitch (EP-A-0 335 553).

The above light-emitting element array uses an element which can control a turn-on threshold level of, e.g., a light-emitting thyristor as a light-emitting element. Transfer of light emission in a scanning direction of the element array is realized on the basis of a principle in that a change in turn-on threshold level caused upon turn-on of one element propagates to the next element in the scanning direction. Therefore, at least one element in the array is always turned on to emit light. At this time, although a light emission amount can be controlled, a current capable of maintaining the ON state must be supplied to the element.

That is, the self-scanning type light-emitting element array as described above cannot be suitably applied to an optical printer which forms a printing image by light emission of pixels. That is, elements to emit light and those not to emit light in the light-emitting element array cannot be set in accordance with a printing image. A series of light emission required for self-scanning of the light-emitting element array appears as a fog on the printing surface and degrades the resolution of the printed image.

In addition, since a turn-on time of each element of the self-scanning light-emitting element array is a fraction of the number of elements in a line, a sufficient light amount required for printing cannot be obtained. For example, when one line of a light-emitting element array consists of 1,000 elements, a light emission time of one element is 1/1,000 of a scanning time of the line.

US-A- 3 696 389 discloses thyristors as light-emitting elements or switches in a display device.

Various aspects and features of the present invention are defined in the appended claims.

Embodiments of the present invention can provide a light-emitting device comprising:
a) a self-scanning switching element array including
   an array of switching elements, turn-on threshold levels of which are able to be controlled,
   coupling means for coupling the elements in an array direction so that an ON element has an influence to change the threshold level of a switching element which is to be turned on next, and
   drive means, connected to the switching elements to supply parallel drive pulses thereto, for transferring turn-on in the array direction at an interval of drive pulses while propagating a change in threshold level in the array direction; and
b) a light-emitting element array, each element of which has a control electrode capable of controlling a turn-on threshold level and a current supply electrode for supplying a light emission control current for light emission,
   wherein a switching element of the switching element array is connected to the control electrode of the light-emitting element so that the light-emitting element is turned on upon turn-on of the switching element to emit light in accordance with the light emission control current, and an ON state is self-maintained.

Accordingly with embodiments of the present invention, a light emission image can be written in the light-emitting element array. Light emission required for scanning does not have to interfere with the image. The duty ratio of turn-on of each light-emitting element may be increased to be larger than the fraction (e.g. 1/1,000) of the number of elements in one line and can be a maximum of 1.

The invention will now be described by way of non-limiting embodiments with reference to the accompanying drawings in which:-
Fig. 1 is a graph showing current-voltage characteristics of a conventional light-emitting element;
Fig. 2 is a schematic sectional view showing a structure of a conventional 3-terminal light-emitting element;
Fig. 3 is a plan view showing a structure of a light-emitting element array;
Figs. 4 and 5 are sectional views of Fig. 3;
Fig. 6 is an equivalent circuit diagram of Fig. 3;
Fig. 7 is an equivalent circuit diagram showing a light-emitting element array using a diode coupling system;
Fig. 8 is an equivalent circuit diagram showing a light-emitting element array using an optical means;
Fig. 9 is a pulse timing chart showing a method of driving a light-emitting element array;
Fig. 10 is a plan view showing the first embodiment of the present invention;
Fig. 11 is a sectional view of Fig. 10;
Fig. 12A is an equivalent circuit diagram of Fig. 10;
Fig. 12B is a view showing a waveform of a write signal Sin;
Fig. 13 is a sectional view showing a transfer light-emitting element array in the first embodiment;
Fig. 14 is a plan view showing the second embodiment of the present invention;
Fig. 15 is an equivalent circuit diagram of Fig. 14;
Fig. 16 is a sectional view showing the third embodiment of the present invention;
Fig. 17 is a block diagram;
Fig. 18 is a p-n image view of Fig. 17;
Fig. 19 is an equivalent circuit diagram of Fig. 17;
Fig. 20 is a pulse timing chart showing a driving method;
Fig. 21 is an equivalent circuit diagram showing the fourth embodiment of a light-emitting device of the present invention;
Fig. 22 is a sectional view showing an arrangement in which the equivalent circuit diagram shown in Fig. 21 is formed on a single semiconductor substrate;
Fig. 23 is a plan view showing an arrangement of the structure shown in Fig. 22;
Fig. 24 is a circuit diagram showing an arrangement of the fifth embodiment of a light-emitting device of the present invention;
Fig. 25 is an equivalent circuit diagram of a part of Fig. 24;
Fig. 26 is a pulse timing chart showing a start pulse and a transfer clock shown in Figs. 24 and 25;
Fig. 27 is a sectional view showing a part of the equivalent circuit diagram shown in Fig. 25;
Fig. 28 is an equivalent circuit diagram of a light-emitting element array in a conventional optical switching system;
Fig. 29 is a view showing an example of a conventional optical switching system; and
Fig. 30 is a view showing an optical switching system adopting the fifth embodiment of the present invention.

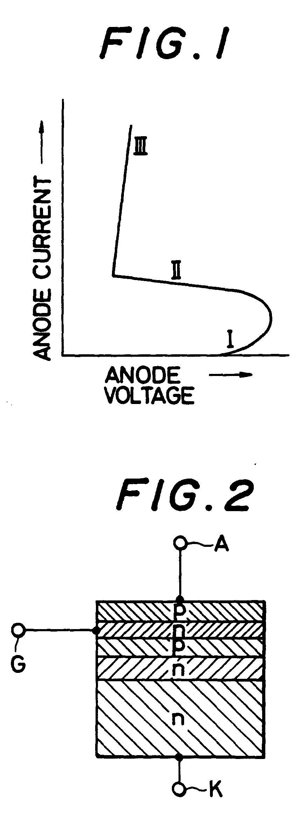

For better understanding of the present invention, self-scanning light-emitting array according to the above referred EP-A-0 335 553 will be described in detail with reference to Figs. 1 to 9.

As described above, a light-emitting thyristor can be used as a constituting element of a light-emitting element array.

Fig. 1 shows current-voltage characteristics of the light-emitting thyristor, and Fig. 2 shows its basic structure. The structure shown in Fig. 2 has a pnpn structure formed on an n-type GaAs substrate, i.e., has the same arrangement as that of a conventional thyristor. Fig. 1 shows a relationship between an anode voltage and an anode current (a voltage and a current of an anode A shown in Fig. 2) obtained when a gate G is open. This relationship exhibits the same S-shaped negative resistance as that of the conventional thyristor. The gate G has a function of controlling an ON voltage, and the ON voltage is a sum of a gate voltage and a diffusion voltage. Therefore, the ON voltage shown in Fig. 1 can be freely controlled by the gate voltage. After the thyristor is turned on, the gate voltage substantially coincides with a cathode voltage. If a cathode is grounded, the gate G has 0 V. In addition, it is known that the ON voltage of this light-emitting thyristor is reduced when light is externally incident thereon.

A laser thyristor can be formed by forming a waveguide in the above light-emitting thyristor in accordance with the same principle as that of an LD (Y. Tashiro et. al., Appl. Phys. Lett. 54(4), 1989 pp. 329 - 331).

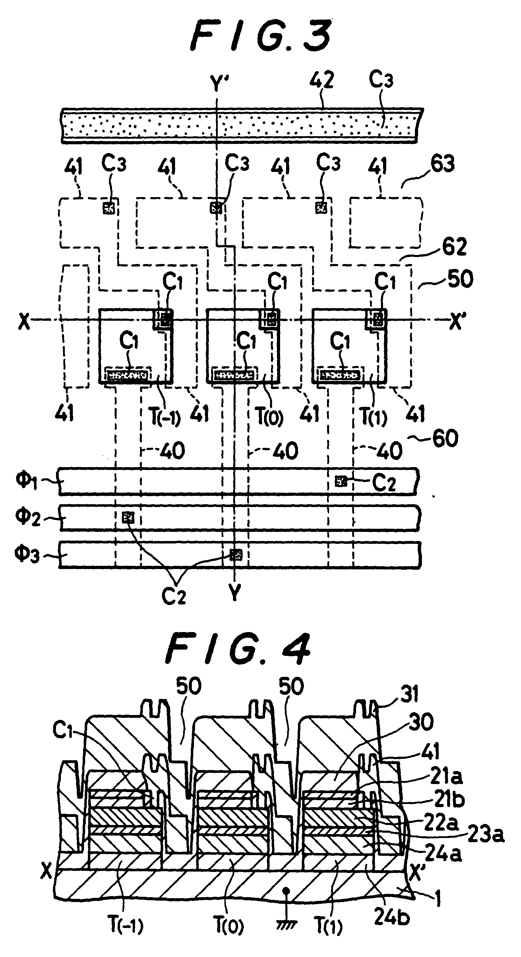

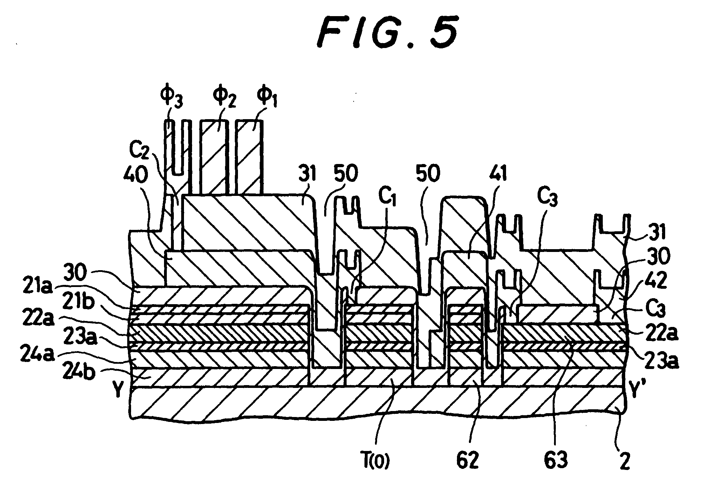

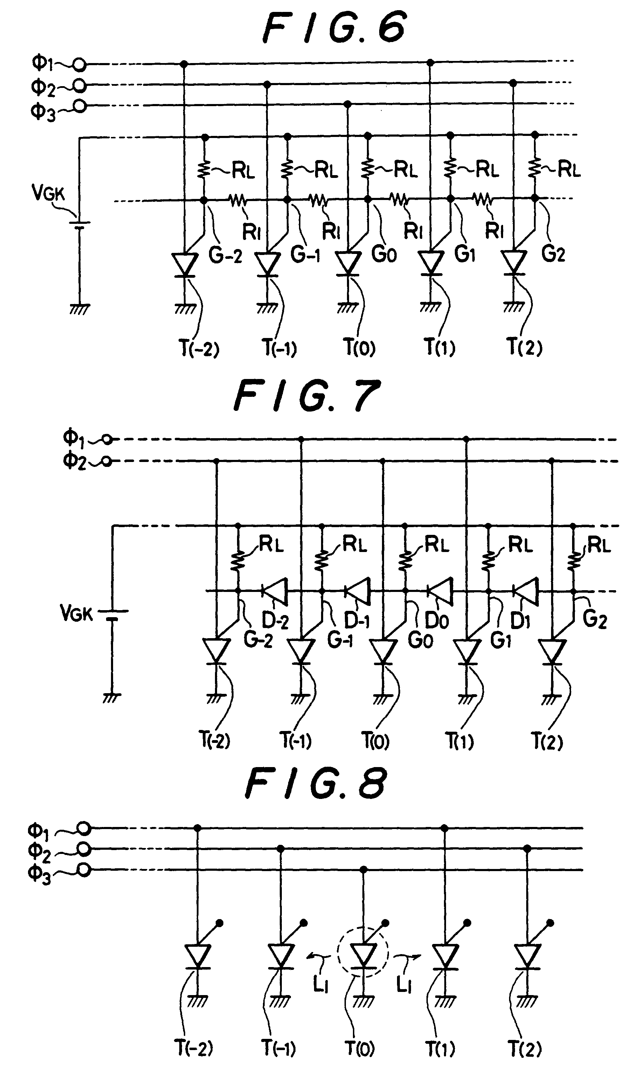

Fig. 3 is a plan view, Fig. 4 is a sectional view showing a portion taken along a line X - X' line in Fig. 3, and Fig. 5 is a sectional view showing a portion taken along a line Y - Y' in Fig. 3. Fig. 6 is an equivalent circuit diagram.

Referring to Fig. 4, a light-emitting element comprises an n-type GaAs layer 24b, an n-type AlGaAs layer 24a, a p-type GaAs layer 23a, an n-type GaAs layer 22a, a p-type AlGaAs layer 21b, and a p-type GaAs layer 21a, all of which are stacked on an n-type GaAs substrate 1. This is a structure in which the p-type GaAs layer 23a and the n-type GaAs layer 22a as active layers are sandwiched between the AlGaAs layers 21b and 24a having a large band width in order to trap carriers in the active layers. A light emission efficiency can be improved by this structure. In this structure, the substrate 1 serves as the cathode of a light-emitting element T, the n-type semiconductor layer 22 serves as its gate, and the p-type semiconductor layer 21 serves as its anode. An insulating protection film 31 is coated on the light-emitting elements T (T(-1) to T(1)), and the elements are isolated from each other.

The gates 22 of the light-emitting elements T are connected with each other via a contact hole C₁ formed in an insulating protection film 30, a metal thin film wiring 41 formed on the insulating protection film 30, a contact hole C₃ formed in the insulating protection film 30, the n-type GaAs layer 22a stacked on the n-type GaAs substrate 1 and isolated from the light-emitting element, the contact hole C₃, the metal thin film wiring 41, and the contact hole C₁.

The anode of each light-emitting element T is connected to a transfer clock line via the contact hole C₁ formed in the insulating protection film 30, the metal thin film wiring 40 formed on the insulating protection film 30, and a contact hole C₂ formed on the insulating protection film 31. In this arrangement, three transfer clock lines φ₁, φ₂ and φ₃ are formed, and the anode of each light-emitting element T is repeatedly connected to one of the lines φ₁, φ₂ and φ₃ in the order of φ₁, φ₂ and φ₃ along the longitudinal direction.

The gate 22 of each light-emitting element T is connected to a power source voltage V_{GK} via the contact hole C₁ formed in the insulating protection film 30, the metal thin film wiring 41 formed on the insulating protection film 30, the contact hole C₃ formed in the insulating protection film 30, the n-type GaAs layer 22a stacked on the n-type GaAs substrate 1 and isolated from the light-emitting element T, the contact hole C₃, and a metal thin film wiring 42 formed on the insulating protection film 30.

An operation of the light-emitting device having the above structure will be described below. Assume that the transfer clock φ₃ goes to a high-level voltage to turn on the light-emitting element T(0). At this time, the gate G₀ of the light-emitting element T(0) is at substantially 0 V. Therefore, a current flows through a resistance network connecting the gates of the light-emitting elements T. For this reason, the voltage of the gate close to the light-emitting element T(0) is reduced most, and an influence becomes smaller as a position is separated. For example, when the next transfer clock φ₁ goes to a high-level voltage, every third elements, i.e., the light-emitting elements T(1) and T(-2) are enabled. However, the voltage of the gate G₁ is lower than that of the gate G₋₂. For this reason, only the light-emitting element T(1) is enabled by setting the power source voltage to be higher than the operation voltage of the light-emitting element T(1) and lower than the operation voltage of the light-emitting element T(-2). By repeatedly performing this operation, the light-emitting elements T can be scanned by using the three transfer clock lines.

As described above, according to the light-emitting device of the prior art, the turn-on voltage or current of each light-emitting element is influenced by an ON state of another light-emitting element (i.e., the light-emitting elements interact with each other), thereby realizing a light emission self-scanning function.

Fig. 7 is an equivalent circuit diagram showing another light-emitting element array. Fig. 7 shows a feature for electrically connecting light-emitting elements T (light-emitting thyristors T(-2) to T(2)) by using diodes. Referring to Fig. 7, reference symbols G₋₂ to G₂ denote the gates of the light-emitting elements T(-2) to T(2); R_{L}, the gate load resistance of each gate; and D₋₂ to D₂, coupling diodes for performing an electrical interaction. Reference symbol V_{GK} denotes a power source voltage of a DC power source. Two transfer clock lines (transfer clocks φ₁ and φ₂) are connected to the anodes of every other light-emitting elements T, respectively.

An operation of Fig. 7 will be described below. Assume that the transfer clock φ₂ goes to a high-level voltage to turn on the light-emitting element T(0). At this time, the voltage of the gate G₀ is reduced close to 0 V. Assuming that the power source voltage V_{GK} is 5 V, the gate voltage of each light-emitting element T is determined on the basis of the network of the resistors R_{L} and the coupling diodes D₋₂ to D₂. In this case, the gate voltage of the element close to the light-emitting element T(0) is reduced most, and the gate voltage is increased as a light-emitting element is separated from the element T(0).

Since, however, a diode has a unidirectivity as its characteristics, an effect of reducing the gate voltage acts on only at the right side of the light-emitting element T(0). That is, the gate G₁ is set at a voltage higher than that of the gate G₀ by a forward rise voltage V_{df} of the diode. In addition, the gates G₂ is set at a higher voltage than that of the gate G₁ by the diode forward rise voltage V_{df}. Since the coupling diode D₋₁ is reverse-biased, no current flows through the gate G₋₁ at the left side of the light-emitting element T(0). Therefore, the gate G₋₁ is set at the same potential as the power source voltage V_{GK}.

The next transfer clock φ₁ is applied to the closest light-emitting elements T(1), T(-1), T(3) and T(-3). Of these elements, the element T(1) has a lowest ON voltage of about 2V_{df}. The element T(3) has the next lowest ON voltage of about 4V_{df}. The ON voltage of the light-emitting elements T(-1) and T(-3) is about V_{GK} + V_{df}.

In this manner, only the light-emitting element T(1) can be turned on by setting the high-level voltage of the transfer clock between 2V_{df} to 4V_{df}. As a result, an ON state transfer operation can be performed.

Fig. 8 is an equivalent circuit diagram showing a light-emitting element array using an optical means. Referring to Fig. 8, the anodes of light-emitting elements (light-emitting thyristors) T(-2) to T(2) are connected to three transfer clock lines to which transfer clocks φ₁ to φ₃ are supplied. This light-emitting element array is arranged such that a part of emitted light is incident on an adjacent light-emitting element, and utilizes a phenomenon in that an ON voltage of the light-emitting element T on which light is incident is reduced.

Assume that the transfer clock φ₃ goes to a high-level voltage to turn on the light-emitting element T(0). In this case, ON voltages of the light-emitting elements T(-1) and T(1) located at both sides of the light-emitting element T(0) is reduced. Therefore, when a high-level voltage is applied to the next transfer clock φ₁, only the light-emitting element T(1) can be turned on. As a result, the light-emitting element array shown in Fig. 8 can perform self-scanning.

Generally, in a light-emitting device for use in an optical printer, not only a light emission point must be moved, but also light emission intensity must be modulated. In the above self-scanning light-emitting device, modulation of light emission intensity can be performed by the following driving method.

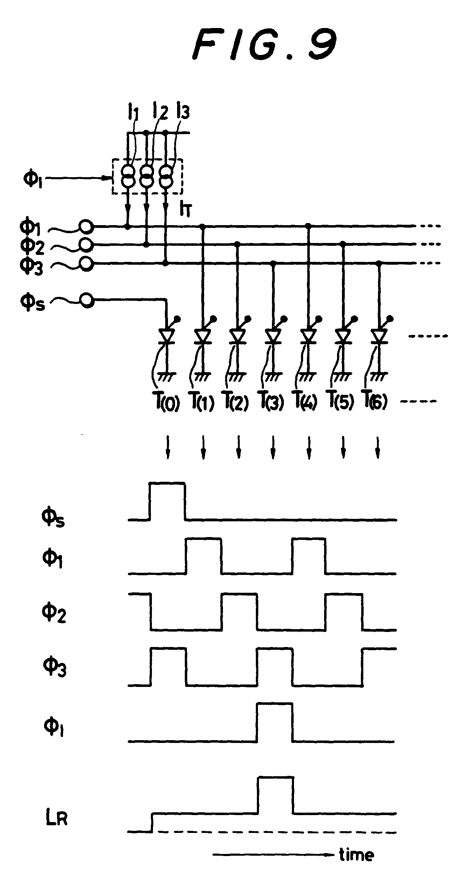

Fig. 9 shows the principle of this driving method. In a circuit diagram shown in Fig. 9, although not shown, the gates of light-emitting elements T(0) to T(6) are connected by the electric means as shown in Fig. 6 or 7 or the optical means as shown in Fig. 8. Any one of transfer clock lines φ₁, φ₂ and φ₃ is repeatedly connected to the anodes of the light-emitting elements T(1) to T(6) in the order of φ₁, φ₂ and φ₃ in the longitudinal direction. Current sources I₁, I₂ and I₃ are connected to the transfer clock lines φ₁, φ₂ and φ₃, respectively, so as to be controlled by a control circuit signal φ_{I}. A start pulse φ_{S} is connected to the anode of the light-emitting element T(0).

A rectangular signal is applied as transfer pulses to the transfer clock lines φ₁, φ₂ and φ₃ with a delay t₁ with respect to a time t. These transfer pulses are set to have a short overlap time.

The rectangular start pulse φ_{S} is applied to the light-emitting element T(0), and the transfer clock φ₁ having a short overlap time with respect to the start pulse φ_{S} and the subsequent transfer clocks φ₂, φ₃ and φ₁ are repeatedly applied. As a result, the light-emitting element array starts self-scanning. Signals synchronized with the transfer clocks φ₁, φ₂ and φ₃ are superposed on the control circuit signals φ_{I} to apply output currents of the current sources I₁, I₂ and I₃ to the transfer clocks. In this manner, a light-emitting element set in a light emission state by self-scanning can emit light more intensely than the other light-emitting elements.

Referring to Fig. 9, in order to increase the luminance of particularly the light-emitting element T(3), the output current from the current source I₃ is applied to the transfer clock φ₃ at the time t at which the light-emitting element T(3) is set in the light emission state by self-scanning.

In the above self-scanning light-emitting device, the luminance of an arbitrary portion can be increased by the method as described above to write an image in, e.g., an optical printer.

If the above method is used, however, as is apparent from light emission intensity L_{R} indicated in a lower portion of Fig. 9, elements except for the element T(3) for writing an image more or less emit light (to be referred to as bias light hereinafter). This light emission is caused by a current for setting an ON state upon transfer of the ON state. For this reason, when the above device is used in an optical printer, light is radiated to some extent on the entire portion of an image to degrade the quality of the image.

In addition, in the conventional method, current sources must be formed in a number corresponding to the number of phases of transfer clocks, resulting in a complicated and expensive driver portion.

Furthermore, in the above self-scanning light-emitting device, an average light emission intensity is low because a light emission duty cycle is low. Therefore, the life of the device is shortened when intense light emission is performed.

That is, in the above self-scanning light-emitting device, always one element is in an ON state (i.e., a light emission state). For this reason, if a light-emitting device having 1,000 bits is arranged, for example, a light emission time of one bit is only 1/1,000 the entire light emission (i.e., a duty cycle of light emission is 1/1,000). Therefore, in order to obtain the same average light amount as that obtained when the duty cycle is 1, a current of 1,000 times or more must be flowed to each light-emitting element. This shortens the life of each light-emitting element to make it difficult to manufacture a long-life light-emitting device.

Embodiments of the present invention will be described in detail below.

### <Embodiment 1>

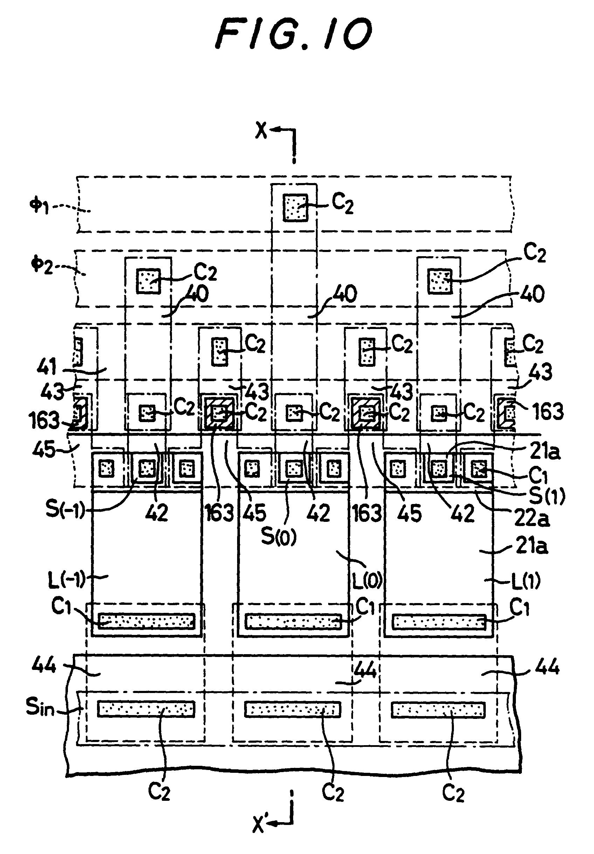

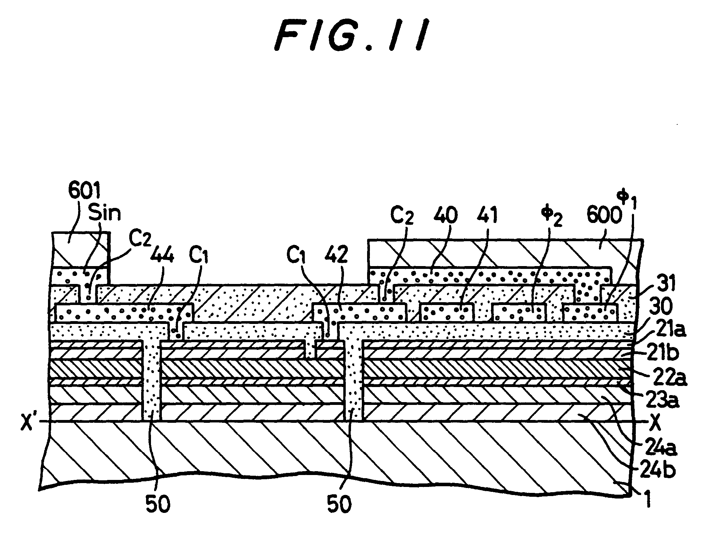

The first embodiment of the present invention is schematically shown in Figs. 10 to 13. Fig. 10 is a plan view showing a schematic arrangement of a light-emitting device of the first embodiment, and Fig. 11 is a sectional view thereof taken along a line X - X' in Fig. 10. A layer arrangement of this embodiment is the same as that of the conventional light-emitting element array shown in Figs. 3, 4 and 5. The manufacturing steps and structure of the first embodiment will be described below.

An n-type GaAs layer 24b, an n-type AlGaAs layer 24a, a p-type GaAs layer 23a, an n-type GaAs layer 22a, a p-type AlGaAs layer 21b, and a p-type GaAs layer 21a are sequentially stacked on an n-type GaAs substrate 1.

The stacked semiconductor layers are isolated into light-emitting elements S by separating grooves 50. In order to manufacture a gate and a unidirective coupling element, the p-type GaAs layer 21a and the p-type AlGaAs layer 21b of each light-emitting element S are partially removed to remain as three islands on the n-type GaAs layer 22a. The three islands consist of one large island and two continuous small islands. The two small islands are repeatedly arranged in the longitudinal direction of the light-emitting element to form a pattern of an island, an island, a valley, an island, an island, a valley, an island, an island and a valley. A set of an island, an island and a valley corresponds to one light-emitting element in which the valley indicates an exposed portion of the n-type GaAs layer 22a.

An insulating film 30 is coated on the entire substrate.

Connection contact holes C₁ are formed in the insulating film 30 at positions on the exposed portion of the n-type GaAs layer 22a and three portions of the p-type GaAs layer 21a.

A T-shaped power source electrode and a gate coupling metal thin film wiring 45 for connecting the n-type GaAs layer 22a of each light-emitting element and the p-type GaAs layer 21a of an adjacent light-emitting element by using the contact hole C₁, a metal thin film wiring 44 for transmitting a clock pulse to the large island-like p-type GaAs layer 21a of the light-emitting element via the contact hole C₁, and the metal thin film wiring 42 for transmitting a drive voltage to the remaining island-like p-type GaAs layer 21a of the light-emitting element via the contact hole C₁ are formed on the insulating film 30.

Phosphor-doped amorphous silicon 163 to be used as a gate-power source electrode resistor R_{L} is coated on a part of the metal thin film wiring 45 to have a thickness of about 1 µm.

The amorphous silicon 163 is isolated in one-to-one correspondence with the light-emitting element.

An insulating film 31 is coated on the entire substrate.

Connection contact holes C₂ are formed in the insulating film 31 at positions on the amorphous silicon 163, the metal thin film wiring 42, and the metal thin film wiring 44.

A write signal line Sᵢₙ for transmitting light emission information to the metal thin film wiring 44 (the node of the light-emitting element) via the contact hole C₂, a power source line 41 for transmitting a power source voltage to the metal thin film wiring 43 (connected to the gate of a scanning circuit element via the amorphous silicon 163) via the contact hole C₂, and clock lines φ₁ and φ₂ for transmitting clock pulses to the metal thin film wiring 40 (the anode of the scanning circuit element) via the contact hole C₂ are formed on the insulating film 31.

The position of one of the contact holes C₂ formed on the metal thin film wiring 40 for coupling the clock lines is alternately selected with respect to the clock lines φ₁ and φ₂ so that the anode of each scanning circuit element is connected to one of the clock lines φ₁ and φ₂. Note that in Fig. 11, reference numerals 600 and 601 denote light-shielding layers for shielding bias light.

In the structure of the above embodiment, since all of the transfer light-emitting elements, the coupling diodes, and the write light-emitting elements can be formed by patterning the p-type GaAs layer 21a and the p-type AlGaAs layer 21b, the manufacturing steps are not so much different from conventional light-emitting element manufacturing steps. That is, although the structure is complicated, the manufacturing steps are not complicated.

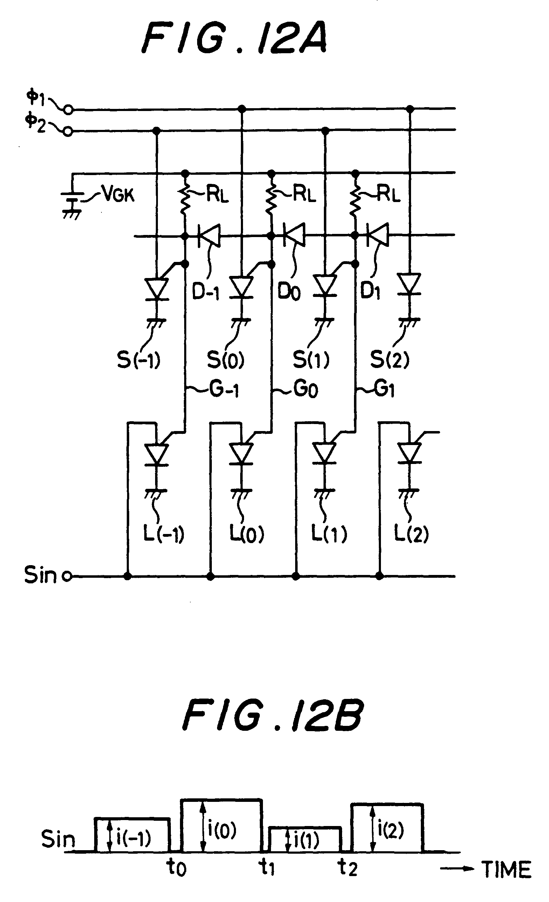

Fig. 12A shows an equivalent circuit diagram of this light-emitting device. As is apparent from Fig. 12, the light-emitting device of this embodiment mainly consists of transfer light-emitting elements S(-1) to S(2) and write light-emitting elements L(-1) to L(2). The arrangement of a portion of the transfer light-emitting elements is exactly the same as the conventional arrangement described above, in which the diode connection shown in Fig. 7 is used. Gates G₋₁ to G₁ of the transfer light-emitting elements S are connected to the gates of the write light-emitting elements L. A write signal Sᵢₙ is applied to the anode of each write light-emitting element L.

An operation of the above light-emitting device will be described below.

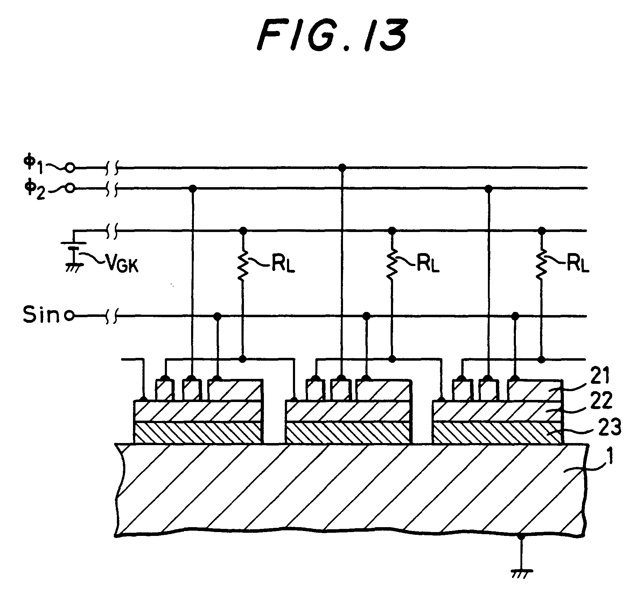

Fig. 13 is a schematic sectional view of a transfer light-emitting element array. A portion of the transfer light-emitting elements operates similarly to the conventional arrangement, i.e., the transfer light-emitting elements S(-1), S(0), S(1), S(2), ..., are sequentially turned on by two-phase clock pulses φ₁ and φ₂.

Assuming that the transfer light-emitting element S(0) is in an ON state, the voltage of the gate G₀ is reduced below V_{GK} (assumed to be 5 V in this case) to be substantially 0 V. Therefore, if the voltage of the write signal Sᵢₙ is higher than a diffusion potential (about 1 V) of a p-n junction, the light-emitting element L(0) can be set in a light emission state. The voltage of the gate G₋₁ is about 5 V, and the voltage of the gate G₁ is about 1 V. Therefore, the write voltage of the light-emitting element L(-1) is about 6 V, and the write voltage of the light-emitting element L(1) is about 2 V. As a result, the voltage of the write signal Sᵢₙ which can be written in only the light-emitting element L(0) falls within the range of 1 to 2 V.

When the light-emitting element L(0) is set in the ON state, i.e., the light emission state, the voltage of the write signal line Sᵢₙ is fixed at about 1 V. Therefore, an error in which another light-emitting element is selected can be prevented. Light emission intensity is determined by a current amounts i₍₋₁₎, i₍₀₎, i₍₁₎, ..., to be flowed into the write signal Sᵢₙ shown in Fig. 12B, and an image write operation can be performed with an arbitrary intensity. In order to transfer the light emission state to the next element, the voltage of the write signal Sᵢₙ line must be reduced to 0 V at times t₀, t₁, t₂, ..., shown in Fig. 12B to temporarily set the light-emitting element L which is emitting light in an OFF state.

In this arrangement, a diode coupling system is used as a coupling system for a control electrode having a threshold voltage or current which can be externally controlled. The coupling system is not limited to the above system but may be the resistance network system as shown in Fig. 6 or the optical coupling system as shown in Fig. 8.

In the above embodiment, amorphous silicon is used as the resistor 163. However, an arbitrary substance can be used as long as the substance has a resistivity similar to that of the resistor 163. In addition, the structure of the resistor is not limited to the above structure. For example, a structure in which a portion of layers stacked to form light-emitting elements is used as a resistance layer can be used.

### <Embodiment 2>

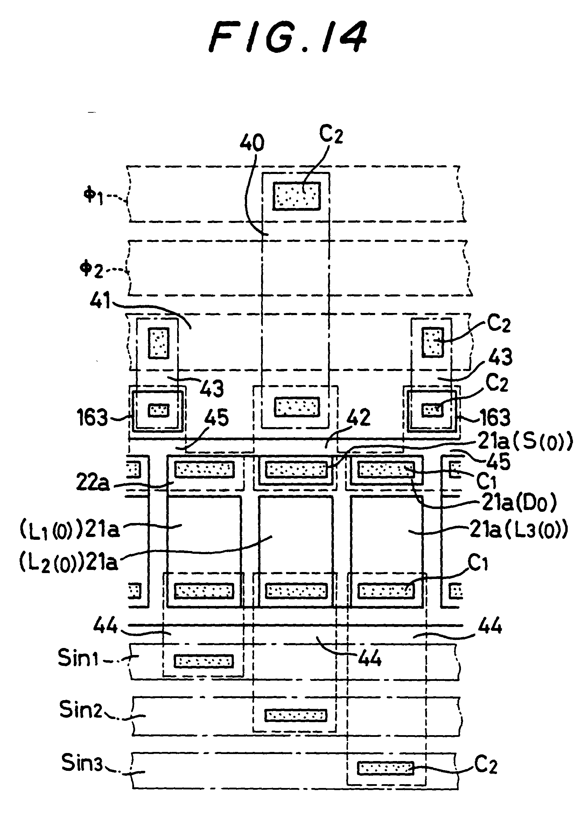

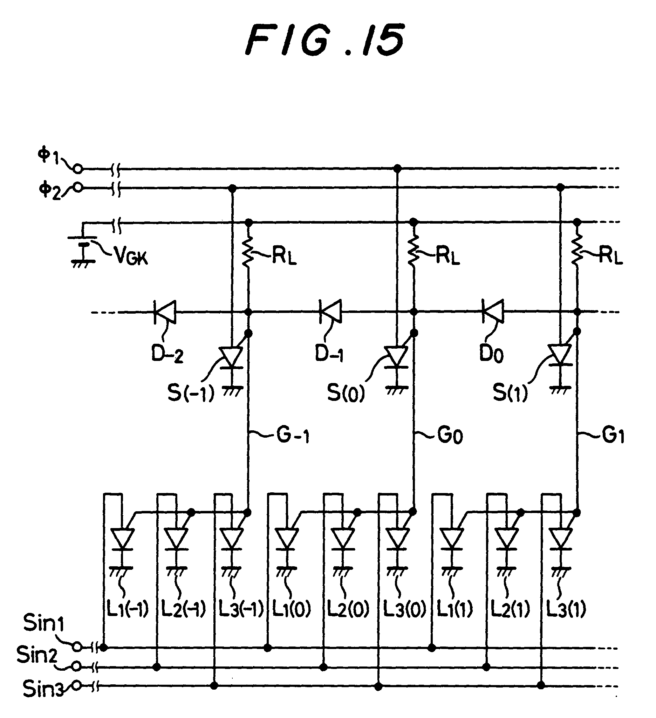

The second embodiment of the present invention will be described below with reference to Figs. 14 and 15. Fig. 14 is a plan view showing a light-emitting device of this embodiment, and Fig. 15 is an equivalent circuit diagram thereof.

An n-type GaAs layer 24b, an n-type AlGaAs layer 24a, a p-type GaAs layer 23a, an n-type GaAs layer 22a, a p-type AlGaAs layer 21b, and a p-type GaAs layer 21a are sequentially stacked on an n-type GaAs substrate 1.

The stacked semiconductor layers are isolated into light-emitting elements S by an isolation groove 50. In order to form a gate and a unidirectional couping element, the p-type GaAs layer 21a and the p-type AlGaAs layer 21b of each light-emitting element S are partially removed to remain as five islands on the n-type GaAs layer 22a. These five islands consist of two small islands and three comparatively large continuous islands. The three comparatively large islands are arranged in the longitudinal direction of the light-emitting element array. The two small islands are repeatedly arranged in the longitudinal direction of the light-emitting element array so as to form a pattern of an island, an island, a valley, an island, an island, a valley, an island, an island and a valley. In this arrangement, one comparatively large island corresponds to one light-emitting element, a set of an island, an island and a valley corresponds to one scanning circuit element coupled to three light-emitting elements, and the valley indicates an exposed gate portion of the n-type GaAs layer 22a.

An insulating film 30 is coated on the entire substrate.

Connection contact holes C₁ are formed in the insulating film 30 at positions on the exposed portion of the n-type GaAs layer 22a and the five portions of the p-type GaAs layer 21a.

The n-type GaAs layer 22a of each scanning circuit element and the p-type GaAs layer 21a of the adjacent scanning circuit element are connected by using the contact hole C₁. A T-shaped metal thin film wiring 45 for coupling a power source electrode and a gate, a metal thin film wiring 44 for transmitting a write signal Sᵢₙ to the three large island-like p-type GaAs layers 21a of the light-emitting element via the contact hole C₁, and a metal thin film wiring 42 for transmitting a drive voltage to the remaining island-like p-type GaAs layers 21a of the light-emitting element via the contact hole C₁ are formed on the insulating film 30.

Phosphorus-doped amorphous silicon 163 to be used as a gate-power source electrode resistor R_{L} is partially coated on the metal thin film wiring 45 to have a thickness of about 1 µm. The amorphous silicon 163 is isolated in one-to-one correspondence with the light-emitting element.

An insulating film 31 is coated on the entire substrate.

Connection contact holes C₂ are formed in the insulating film 31 at positions on the amorphous silicon 163, the metal thin film wiring 42, and the metal thin film wiring 44.

Write lines (Sᵢₙ₁, Sᵢₙ₂ and Sᵢₙ₃) for transmitting a write signal to the metal thin film wiring 44 (the anode of the light-emitting element) via the contact hole C₂, a power source line 41 for transmitting a power source to the metal thin film wiring 43 (connected to the gate of the scanning circuit element) via the contact hole C₂ (the amorphous silicon 163), and clock lines φ₁ and φ₂ for transmitting a transfer clock to the metal thin film wiring 40 (the anode of the scanning circuit element) via the contact hole C₂ are formed on the insulating film 31.

The positions of the contact holes C₂ formed on the write line coupling metal thin film wiring 44 are selected such that the anode of each scanning circuit element is connected to one of the write lines Sᵢₙ₁, Sᵢₙ₂ and Sᵢₙ₃ in the order of Sᵢₙ₁, Sᵢₙ₂ and Sᵢₙ₃.

Fig. 15 is an equivalent circuit diagram of the above embodiment, which is different from that of the first embodiment in that the light-emitting elements are grouped into blocks each having three elements, light-emitting elements in one block are controlled by one scanning circuit element, and a write line is independently connected to each light-emitting element in the block to control light emission of the element. Referring to Fig. 15, light-emitting elements L₁(-1), L₂(-1) and L₃(-1), light-emitting elements L₁(0), L₂(0) and L₃(0), and light-emitting elements L₁(+1), L₂(+1) and L₃(+1) constitute blocks.

An operation of the second embodiment is the same as the first embodiment except that light emission which is written in each element in accordance with the write signal Sᵢₙ in the first embodiment is simultaneously written in a plurality of elements to emit light and light emission is transferred in units of blocks.

Assuming that the above self-scanning light-emitting device is used as light source for a generally known optical printer such as an LED printer, in order to print a material corresponding to a short side (= about 21 cm) of an A-4 sheet with a resolution of 16 dots/mm, about 3,400 bits of light-emitting elements are required.

In the light-emitting device according to the first embodiment, always one of points emits light, and an image is written by changing the intensity of light emission. When an optical printer is arranged by using this device, a luminance which is 3,400 times that of a normally used optical printer LED array. The conventional array is controlled by a drive IC such that LEDs located at points in which images are written simultaneously emit light. That is, if a light emission efficiency is the same, a current which is 3,400 times that of the conventional LED array must be flowed. Note that a light emission time is shortened to be 1/3,400 that of the conventional LED array. In general, however, when a current amount is increased, a life of a light-emitting element is acceleratedly shortened. Therefore, although a duty cycle of 1/3,400 can be obtained, the life of the light-emitting device of the first embodiment is shorter than that of the conventional LED printer.

According to the second embodiment, however, assuming that the bit total number is the same, a light emission time of one element is three times that of the first embodiment since three elements are included in one block. Therefore, since only a current 1/3 that of the first embodiment need be flowed to a light-emitting element in an ON state, the life of the device can be prolonged as compared with that of the conventional system.

In the above embodiment, three elements are included in one block. However, as the number of elements is increased, a write current amount can be decreased to prolong the life of the device.

### <Embodiment 3>

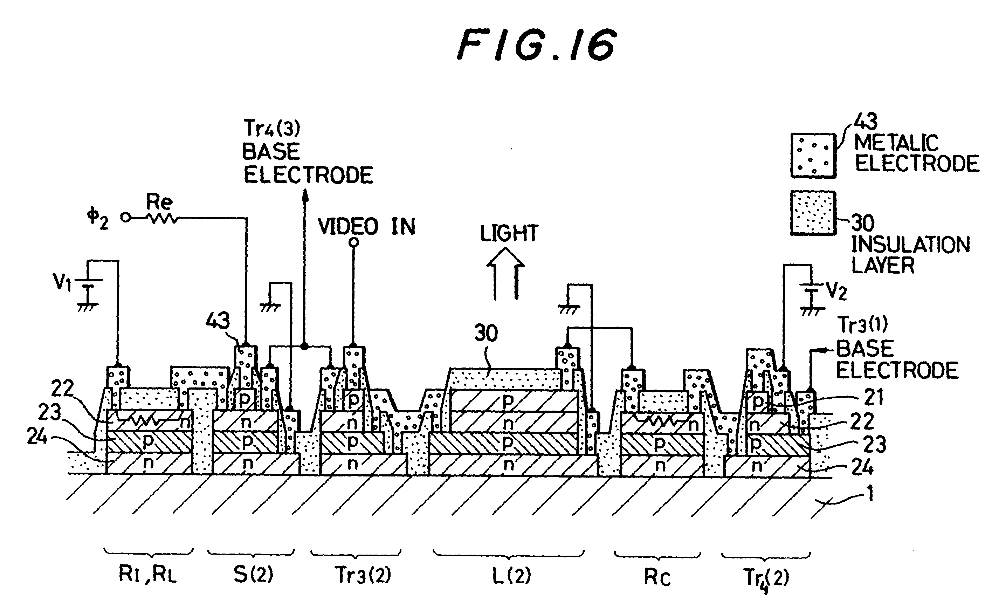

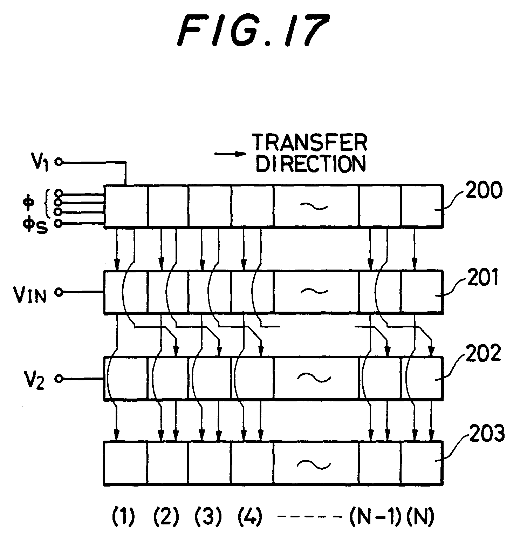

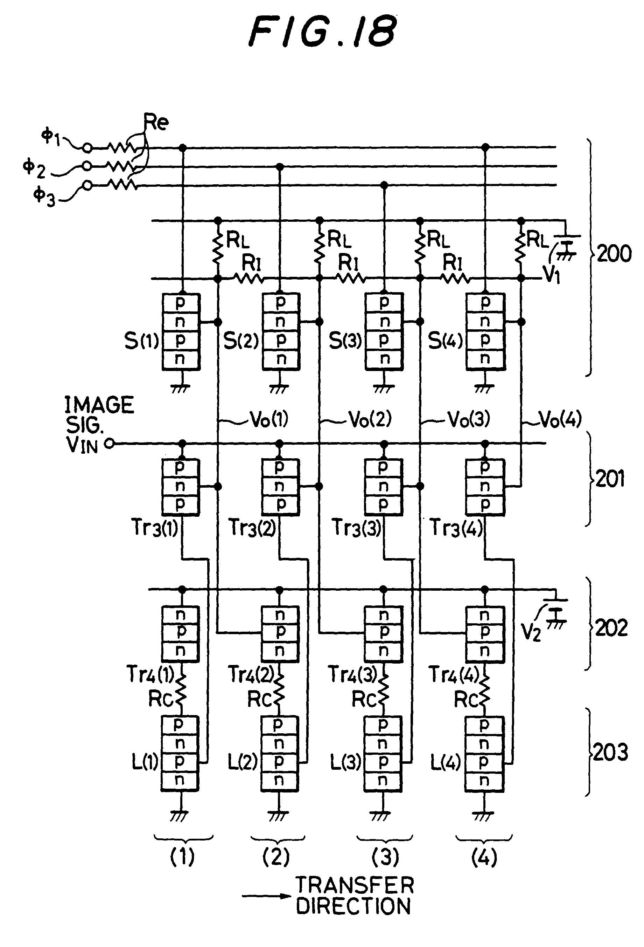

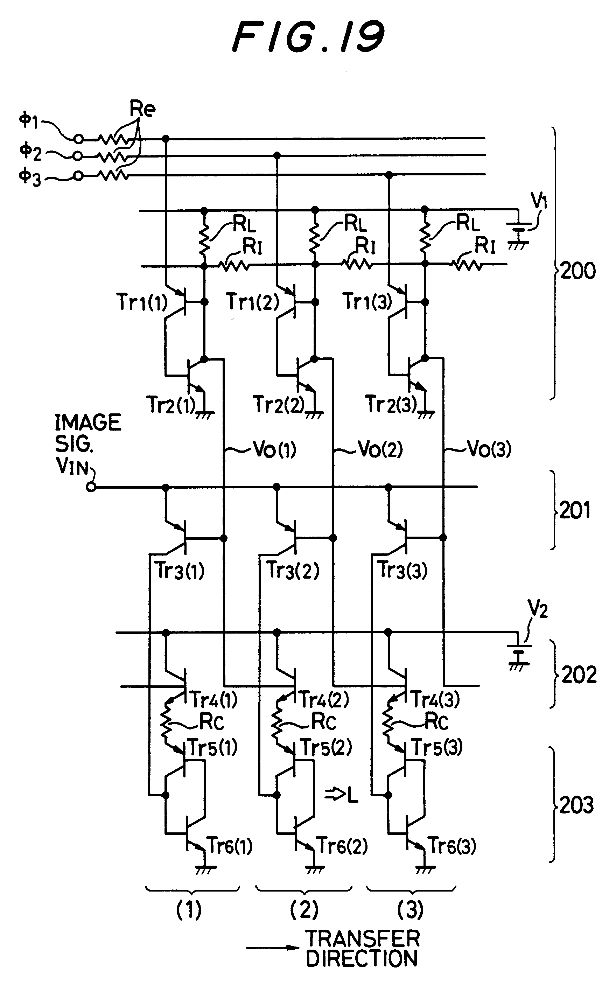

A light-emitting device according to the third embodiment of the present invention which can further improve a duty cycle will be described below with reference to Figs. 16, 17, 18 and 19. Fig. 16 is a sectional view showing the light-emitting device of this embodiment, Fig. 17 is a block diagram of Fig. 16, Fig. 18 is a p-n image of Fig. 17, and Fig. 19 is a circuit diagram equivalent to the p-n image shown in Fig. 18.

Fig. 17 is a block diagram showing the third embodiment. Referring to Fig. 17, a light-emitting element array is constituted by a shift register 200, a write switching array 201, a reset switching array 202, and a light-emitting memory element array 203. Each array consists of N elements from Nos. (1) to (N).

The shift register 200 is driven by a bias voltage V₁ from a power source, a plurality of transfer clocks φ and a start pulse φ_{S} to transfer (self-scan) an ON state. A transfer direction is from left to right, i.e. from (1) to (N).

The write switching array 201 is a switching array for writing an input image signal V_{IN} into the light-emitting memory element array 203 and operates in synchronism with the shift register 200. That is, the write switching array 201 writes an image signal V_{IN}(t) in a bit of the light-emitting memory element array 203 corresponding to a bit of the shift register 200 in an ON state at a time t.

In this embodiment, this write operation of the image signal V_{IN} is set to be performed in the same number for each bit. The written light emission information is held in the light-emitting memory element array 203.

The shift register 200 is arranged to simultaneously address the reset switching array 202. In this case, however, a shift register output is connected to an element advanced by one bit in a transfer direction such that a shift register output from a bit of No. (1) is connected to a reset switch of No. (2) and a shift register output from a bit of No. (3) is connected to a reset switch of No. (4). When the reset switch is addressed, the light-emitting memory element is reset. That is, when a certain bit of the shift register is turned on, a light-emitting memory element advanced by one bit in the transfer direction is returned to a non-light emission state (OFF state) regardless of whether it is in a light emission state or a non-light emission state.

With this arrangement, a change in image signal along with time is written as a position change in light-emitting memory element, and image information is written in the light-emitting memory element to form an image pattern formed by light emission. When the next image signal is to be written, the image information written by the reset switch is erased, and new image information is written immediately after erasure.

For this reason, the light-emitting elements are substantially constantly set in an ON state to obtain a duty cycle of substantially 1.

In this arrangement, only one shift register 200 is provided, and its output is used in both image signal write and reset operations. However, two shift registers may be used in the image signal write and reset operations, respectively.

Fig. 19 is an equivalent circuit diagram of this embodiment corresponding to the arrangement shown in Fig. 17.

The shift register 200 has the same arrangement as that of the prior art described above. Each of thyristors S(1) to S(4) is constituted by two transistors (Tr₁ and Tr₂), and its gate is connected to an adjacent thyristor S and a power source V₁ via resistors R_{L} and R_{I}. Outputs from the shift register are extracted from the gates and displayed as output voltages V₀(1) to V₀(3). (1) to (3) are numbers of the respective bits. In Fig. 19, each resistor Re is a resistor for limiting a current on a clock line.

Pnp transistors Tr₃(1) to Tr₃(4) are used as write switches, and npn transistors Tr₄(1) to T₄(4) are used as reset switches. Each resistor Rc is a resistor for limiting a current flowing in a corresponding one of the light-emitting memory elements L(1) to L(4). A light-emitting thyristor which is displayed by a combination of two transistors (Tr₅ and Tr₆) is used as each of the light-emitting memory elements L(1) to L(4). When this light-emitting thyristor is turned on, it is kept ON until a power source is switched off. This characteristic of the light-emitting thyristor is used as a light emission memory function.

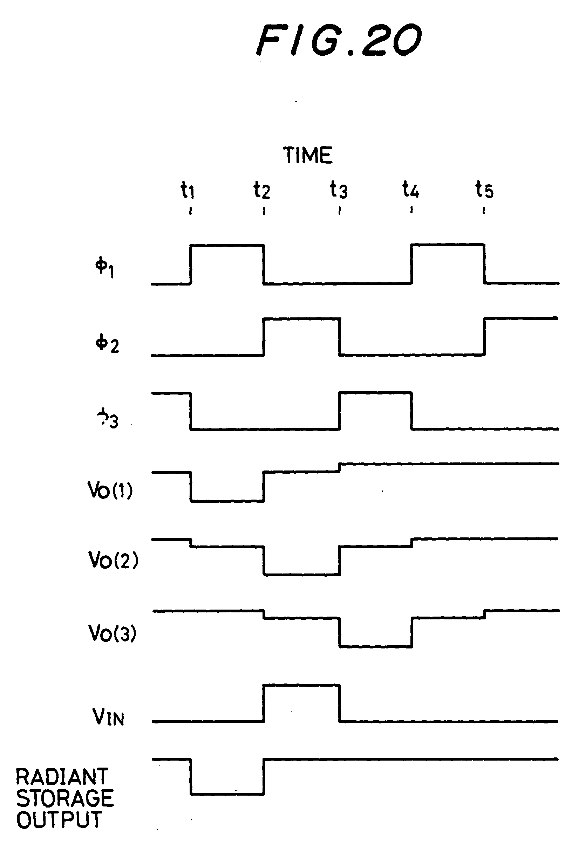

An operation of this equivalent circuit will be described below with reference to a pulse timing chart shown in Fig. 20. Referring to Fig. 20, reference numerals t₁ to t₅ denote times. Transfer clocks are represented by φ₁ to φ₃ in which φ₁ is at high level from t₁ to t₂ and t₄ to t₅, φ₂ is at high level from t₂ to t₃, and φ₃ is at high level from t₃ to t₄. Outputs V_{O}(1) to V_{O}(3) from the shift register 200 are extracted in synchronism with φ₁ to φ₃ and supplied as low-level signals. An image signal V_{IN} is at high level from t₂ to t₃ and written in a light-emitting element of bit number (2).

A time period between the times t₁ and t₂ will be described. In this period, the output V_{O}(1) is extracted as a low-level output from the shift register 200. This output V_{O}(1) is connected to the base of the transistor Tr₃(1) as a write switch to set the transistor Tr₃(1) in a write enable state. In this case, however, since the image signal V_{IN} is at low level, no write operation is performed for the light-emitting memory element L. The Output V_{O}(1) is simultaneously applied to the base of the transistor Tr₄(2) as a reset switch and reduced to be about 0 V. For this reason, an emitter voltage of the transistor Tr₄(2) is reduced to be about 0 V to turn off the light-emitting element. Therefore, the light-emitting memory element of bit No. (2) is reset.

A time period between the times t₂ and t₃ will be taken into consideration. In this period, the shift register output is V_{O}(2), and this output is applied to the base of the transistor Tr₃(2). Since the image signal V_{IN} is at high level, a current is flowed into the light-emitting memory element through the transistor Tr₃(2). This current serves as a base current of the transistor Tr₆(2) to turn on the light-emitting memory element L(2) of bit No. (2). This light emission is maintained until the next reset signal is input. At this time, the light-emitting memory element L(3) of bit No. (3) is reset by V_{O}(2).

A current to be flowed into the light-emitting memory element L is limited by the resistor Rc. Since a duty cycle is increased, only a small amount of light emission current need be flowed to realize a highly reliable light-emitting device.

In this embodiment, an operation corresponding to three phases of transfer clocks has been described. However, the device of this embodiment can operate by using four or more phases of transfer clocks.

Although the light-emitting elements are arranged in a line in the above embodiment, they need not be linearly arranged but can be arranged in a zig-zag manner, or the number of lines may be increased to two from the middle of the arrangement.

In this embodiment, the description is limited to a light-emitting thyristor. However, any device can be used as long as it has a similar function, e.g., a laser thyristor may be used as a light-emitting element.

In this embodiment, the light-emitting element may be constituted by a single part or may be integrated by a certain method.

Fig. 16 shows an arrangement in which the equivalent circuit shown in Fig. 19 is integrated. Fig. 18 is a view showing the equivalent circuit shown in Fig. 19 rewritten by a p-n image. Each bit of the shift register 200 is represented by a pnpn 4-layer arrangement, and the light-emitting memory element L is similarly represented by a pnpn arrangement. The bits having the pnpn arrangement of the shift register 200 are represented by S(1) to S(4), and the bits of the light-emitting memory element are represented by L(1) to L(4). Fig. 16 shows a structure in which this arrangement is formed on a semiconductor substrate.

Fig. 16 is a sectional view showing the structure of bit No. (2). In this structure, an n-type GaAs layer 24, a p-type GaAs layer 23, an n-type GaAs layer 22, and a p-type GaAs layer 21 are sequentially stacked on a semi-insulating GaAs substrate 1. These semiconductor layers are isolated by an insulating film 30 into elements each having a specific function and electrically connected by a metal electrode 43. Resistors R_{L} and R_{I} are resistive elements formed by the n-type GaAs layer 22 and having an end connected to a power source V₁. S(2) of the shift register is constituted by the four layers 21, 22, 23 and 24. Tr₃(2) of the write switch is constituted by the layers 21, 22 and 23, and the layer 24 which is unnecessary is connected to the layer 23 to cancel an effect of the layer 24.

L(2) of the light-emitting memory element is constituted by the four layers 21, 22, 23 and 24. The layers 23 and 24 of the write switch Tr₃(2) are connected to the layer 23 of the shift register L(2) to serve as a write electrode of the light-emitting memory element L. Similar to the resistors R_{L} and R_{I}, the resistor Rc is formed of the n-type GaAs layer 22. Tr₄(2) of the reset switch is constituted by the three layers 22, 23 and 24, and the layer 21 which is unnecessary is connected to the layer 22. The layer 23 is connected to the base (layer 21) of the write switch Tᵣ₃(1).

By using the structure shown in Fig. 16, the function described above can be perfectly achieved.

Note that GaAs is used as a semiconductor in the first to third embodiments described above, but another semiconductor can be used.

In this embodiment, the structure of the light-emitting memory element is not limited to the pnpn structure. For example, a structure having six or more layers can be used to achieve the same effect. In addition, a thyristor called a static induction (SI) thyristor or a field-controlled thyristor (FCT) can be used to realize the same light-emitting memory function.

This self-scanning light-emitting device can be applied to a write head of an optical printer or a display to decrease cost and improve performance of such equipment.

As described above, according to the first to third embodiments, a "transfer light-emitting element" for performing ON state transfer which causes bias light is isolated from a "storage light-emitting element" for performing an image storage operation. Therefore, influence of bias light from the transfer light-emitting element on the image write operation can be prevented by a light-shielding layer arranged thereon. As a result, almost no influence of the bias light is produced to improve the quality of a printer or the like.

In addition, since an image write signal can be input directly to a storage light-emitting element without going through a transfer clock line, an arrangement of a driver can be simplified.

Furthermore, since light-emitting elements are grouped into blocks and a write operation is independently performed for each element in a block, a current amount during the write operation can be reduced to prolong the life of the light-emitting element.

A light-emitting device having a duty cycle of substantially 1 can be manufactured by simple manufacturing steps by using a light-emitting memory element array. Therefore, various problems of the number of wire bondings, a drive IC, and the difficulties in realization of compactness and a small pitch can be solved.

The above first to third embodiments can be applied to an optical printer, a display and the like to improve performance and reduce cost of such equipment.

### <Embodiment 4>

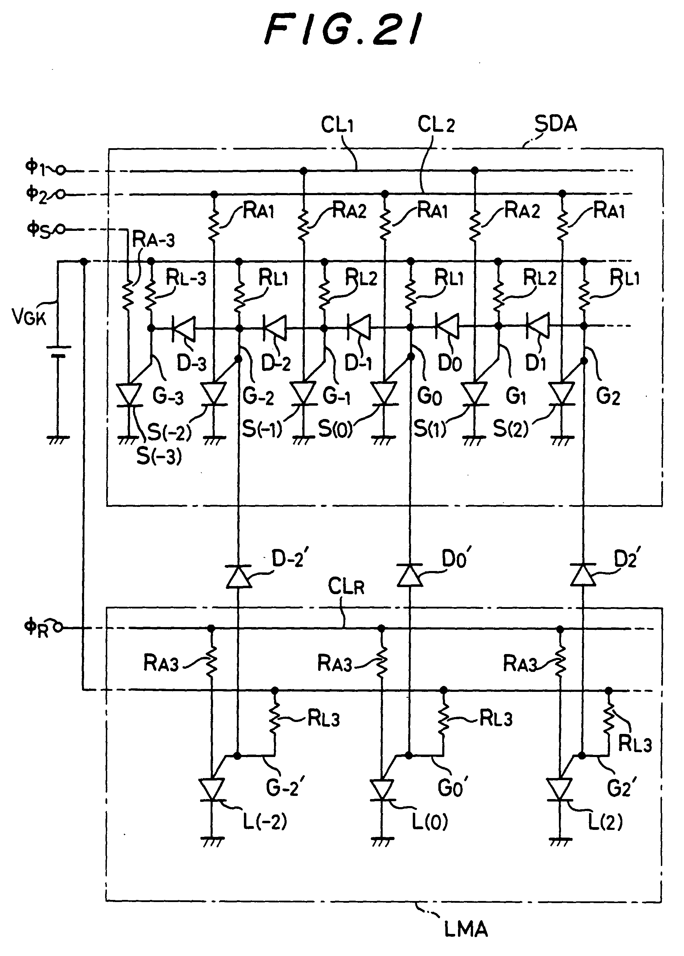

Fig. 21 is an equivalent circuit diagram showing the fourth embodiment of a light-emitting device according to the present invention. Referring to Fig. 21, a switching element array SDA and a light-emitting element array LMA are separately illustrated in upper and lower portions.

The switching element array SDA having a shift register function will be described below. Reference symbols S(-2) to S(2) denote switching elements (thyristors each having a pnpn structure); φ₁ and φ₂, transfer clocks for driving the switching element array SDA; CL₁, a clock line to which the transfer clock φ₁ is supplied; and CL₂, a clock line to which the transfer clock φ₂ is supplied. Gates G₋₂ to G₂ (first control electrode) of the switching elements S(-2) to S(2) are connected by coupling diodes D₋₂ to D₁ (first electric means).

Since the above diode coupling system is adopted, the switching element array SDA can perform information transfer operation by using the two-phase transfer clocks φ₁ and φ₂.

Reference symbols R_{A1} and R_{A2} denote anode load resistors for connecting the anodes of the switching elements S(-2) to S(2) to one of the clock lines C_{L1} and C_{L2}. These anode load resistors R_{A1} and R_{A2} limit a current amount when the switching elements S(-2) to S(2) are in an ON state. The cathodes of the switching elements S(-2) to S(2) are grounded.

Reference symbols R_{L1} and R_{L2} denote gate load resistors (second electric means) for connecting the gates G₋₂ to G₂ of the switching elements S(-2) to S(2) to a DC power source of a power source voltage V_{GK}. These gate load resistors R_{L1} and R_{L2} limit a current amount to be flowed from the DC power source of the power source voltage V_{GK} to the gates G₋₂ to G₂. The gates G₋₂, G₀ and G₂ are connected to the cathodes of diodes D₋₂', D₀' and D₂' (third electric means).

In the switching element array SDA shown in Fig. 21, a switching element S(-3) is formed at the left side of the switching element S(-2). A gate G₋₃ of the switching element S(-3) is connected to the gate G₋₂ of the switching element S(-2) by a coupling diode D₋₃ similar to the coupling diode D₋₂. The gate G₋₃ of the switching element S(-3) is connected to the DC power source of the power source voltage V_{GK} via a gate load resistor R_{L-3}.

The anode of the switching element S(-3) is connected to a terminal for receiving a start pulse φ_{S} via an anode load resistor R_{A-3}. The cathode of the switching element S(-3) is grounded. Note that although a current source for modulating a light emission intensity is provided for the terminal or line for receiving the start pulse φ_{S}, this current source is not shown in Fig. 21.

The light-emitting element array LMA will be described below. Reference symbol φ_{R} denotes a clock (scanning signal) for controlling permission/inhibition of an information write operation into light-emitting elements (light-emitting thyristors) L(-2), L(0) and L(2) and resetting a written state; and CL_{R}, a current supply line to which the clock φ_{R} is supplied.

Reference symbols R_{A3} denote anode load resistors for connecting the anodes of the light-emitting elements L(-2), L(0) and L(2) to the current supply line CL_{R}. These anode load resistors R_{A3} limit a current amount when the light-emitting elements L(-2), L(0) and L(2) are in an ON state. The cathodes of the light-emitting elements L(-2), L(0) and L(2) are grounded.

Reference symbols R_{L3} denote gate load resistors for connecting gates (second control electrodes) G₋₂', G₀' and G₂' of the light-emitting elements L(-2), L(0) and L(2) to the DC power source of the power source voltage V_{GK}. These gate load resistors R_{L3} limit a current amount flowed from the DC power source of the power source voltage V_{GK} to the gates G₋₂', G₀' and G₂'. The gates G₋₂', G₀' and G₂' are connected to the anodes of diodes D₋₂', D₀' and D₂' (third electric means).

That is, in Fig. 21, the gates G₋₂, G₀ and G₂ of the switching elements S(-2), S(0) and S(2) are connected to the gates G₋₂', G₀' and G₂' of the light-emitting elements L(-2), L(0) and L(2) via the diodes D₋₂', D₀' and D₂', respectively.

An operation of the switching element array SDA will be described below.

Assume that a high- or low-level voltage is supplied as the start pulse φ_{S} to the switching element S(-3). In this case, if the high-level voltage is higher than a voltage sum of the power source voltage V_{GK} and a diffusion voltage V_{dif}, the switching element S(-3) is turned on. If a low-level voltage of the start pulse φ_{S} to be supplied next is lower than the ON state maintaining voltage of the switching element S(-3), the switching element S(-3) is turned off.

The gate voltage of the switching element S(-3) is substantially 0 V in the ON state and is the same as the power source voltage V_{GK} in the OFF state. When the gate voltage of the switching element S(-3) is substantially 0 V, the gate voltage of the switching element S(-2) is reduced below the turn-on voltage of the switching element S(-2) by a coupling diode D₋₃ (not shown). Therefore, the switching element S(-2) can be turned on by the transfer clock φ₂.

This ON state is sequentially transferred to the right in Fig. 21 by the transfer clocks φ₁ and φ₂. That is, the ON state is written in the switching element array SDA by the high-level voltage of the start pulse φ_{S}, and this state is sequentially transferred to the right.

If all the bits are in an ON state, however, this ON state cannot be transferred by the arrangement of this switching element array. Therefore, ON and OFF states are repeatedly transferred every other bits. That is, high- and low-level waveforms of the start pulse φ_{S} must be alternately supplied in synchronism with the transfer clocks φ₁ and φ₂.

Assuming that effective information is present in ON and OFF states of only even-number bits and the ON and OFF states are 1 and 0, respectively, 1 or 0 is written by the start pulse φ_{S}, and 1 and 0 are transferred by the transfer clocks φ₁ and φ₂. In this manner, a signal (information) of 1 or 0 is written in the switching element array SDA.

An operation of the light-emitting element L(-2) (L(0) and (L(2)) will be described below.

Assuming that the light-emitting element L(-2) is 0, the light-emitting element L(-2) is not turned on if the voltage of the clock φ_{R} is 0 V. That is, the light-emitting element L(-2) is set in a write inhibition state. If the voltage of the clock φ_{R} is set between the ON state maintaining voltage of the light-emitting element L(-2) and a voltage of V_{GK} + V_{dif}, the light-emitting element L(-2) is set in a write enable state. When the voltage of the gate G₋₂' is changed, the light-emitting element L(-2) can be set in an ON state.

An information write operation from the switching element array SDA to the light-emitting element array LMA will be described below.

As described above, information of 1 or 0 is written in the switching element array SDA. After the information is written in the last bit, the transfer clocks φ₁ and φ₂ are set in low- and high-level states. In this manner, the information transfer operation is finished, and the information written in the switching element array SDA is held (especially in even-number bits).

In each even-number bit of the switching element array, the gate voltage of a switching element S in an ON state is substantially 0 V, and the gate voltage of a switching element S in an OFF state is about twice the voltage V_{dif}. Note that the gate voltage of the switching element S in an OFF state is about twice the voltage V_{dif} when a closest even-number bit located in a direction opposite to the transfer direction is in an ON state and is higher than the voltage about twice the voltage V_{dif} if otherwise. The voltage V_{dif} is a diffusion potential of the p-n junction.

The gate voltages of the switching elements S(-2), S(0) and S(2) are transmitted to the gates G₋₂', G₀' and G₂' of the light-emitting elements L(-2), L(0) and L(2) by the diodes D₋₂', D₀' and D₂', respectively. Therefore, the gate voltage of each of the light-emitting elements L(-2), L(0) and L(2) is the voltage V_{dif} in an ON state and is three times or more the voltage V_{dif} in an OFF state. The turn-on voltage of the light-emitting element is twice the voltage V_{dif} in an ON state and is four times the voltage V_{dif} in an OFF state.

The clock φ_{R} is temporarily set at 0 V to eliminate the entire light emission (i.e., reset the device) and is increased up to a high-level voltage V_{HR} thereafter. If the voltage V_{HR} is set within the range of:${\text{2V}}_{\text{dif}} {\text{< V}}_{\text{HR}} {\text{< 4V}}_{\text{dif}} \text{,}$ a light-emitting element L corresponding to a switching element S in an ON state is turned on, and a light-emitting element L corresponding to a switching element S in an OFF state is kept off.

The information of 1 or 0 written in the switching element array SDA is, therefore, directly written in the light-emitting element array LMA.

Thereafter, the voltage V_{HR} is reset to be a value higher than the ON state maintaining voltage of the light-emitting element and lower than a voltage which is twice the voltage V_{dif}. As a result, the light-emitting element L is not influenced by the gate voltage of the switching element S to keep holding the written information. While the light-emitting element array LMA is kept in the information holding state, the next information is written in the switching element array SDA as in the same manner as described above.

Subsequently, the clock φ_{R} is set at a low-level voltage to reset each light-emitting element L. After the elements are reset, information is written in the light-emitting element array LMA. In this manner, a series of operations are repeatedly performed.

A case in which the light-emitting device shown in Fig. 21 is applied to a write light source of an optical printer will be described below.

Assuming that the light-emitting device has light-emitting elements L having 2,048 bits, switching elements S require 4,096 bits which is twice that of the light-emitting elements L. Since a current amount of a write light source of an optical printer is about 5 mA, a current of about 10 A flows if the light-emitting elements L of all the bits are in a light emission state. It is experimentally found that a current required for information transfer from the switching elements S is 0.5 mA when the gate load resistor R_{L3} is 30 kΩ. Therefore, if the light-emitting elements L of all the bits are in a light emission state, the current is about 1 A.

Note that this current amount for information transfer is about 10% of a current of 10A which is required for optical printing and therefore poses no practical problem.

By reducing the voltages of the transfer clocks φ₁ and φ₂ to be 0 V when information from the switching element S is moved to the light-emitting element L, the entire switching element array SDA is set in an OFF state to perform resetting. When this method is used, a current amount is equivalently reduced if a time required for the switching element S to be turned on is taken into consideration. That is, the current amount is equivalently reduced to be about 0.5 A from 1 A described above.

If only one data input terminal is provided to receive the start pulse φ_{S} with respect to 2,048 bits of the light-emitting elements L, an information transfer rate must be considerably high. However, the information transfer rate can be decreased by providing a plurality of data input terminals. For example, a chip of the light-emitting elements L may be formed in units of 64 or 128 bits so that information is input to each chip.

When information is parallelly input in units of 128 bits, the number of data input terminals is 10 with respect to 2,048 bits. For this reason, the information transfer rate can be decreased to be 1/20. Therefore, the light-emitting device can operate with a sufficient time.

In order to prevent variations in light amounts of output light from the light-emitting elements L, the anode load resistor R_{A3} can be finely adjusted by using a laser or the like. As a result, a light-emitting device having no variation in light amounts of output light can be obtained.

In the arrangement shown in Fig. 21, the characteristics of the coupling diodes D₋₂ and D₀ connected to the right side of even-number bits of the switching element array SDA are different from those of the coupling diodes D₋₁ and D₁ connected to the right side of odd-number bits thereof. Therefore, it is important to use different operation currents and the like for the even-number and odd-number bits to optimize them. For this reason, R_{L2} < R_{L1} and R_{A1} < R_{A2} are preferably set. In this case, the light-emitting device can operate more stably at a higher speed.

Although the arrangement called a diode coupling system is used in Fig. 21, the coupling system is not limited to this one. For example, the resistor coupling system using the resistor R_{I} as shown in Fig. 6 or the optical coupling system using a light emission function and light reception function of the switching element S as shown in Fig. 8 may be used.

The number of transfer clocks is two (two phases) in Fig. 21, but three (three phases) or more clocks can be used. When the switching element S is driven by three phases, the light-emitting element L of one bit corresponds to the switching elements S of three bits.

A direct transition type semiconductor represented by GaAs is generally used to manufacture the light-emitting device (device) as described above, but the material is not limited to this one.

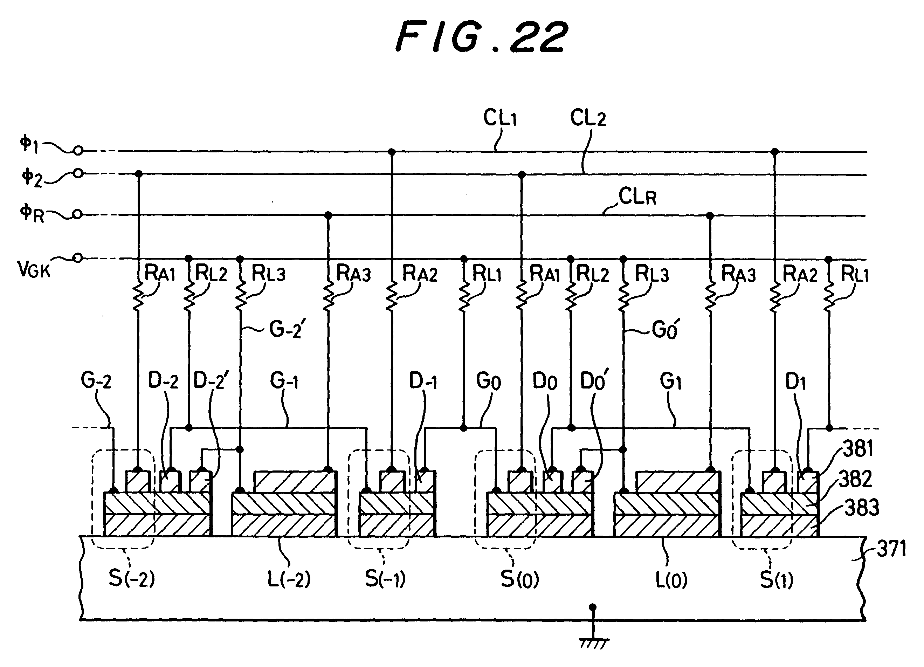

Fig. 22 is a sectional view showing an arrangement in which the equivalent circuit shown in Fig. 21 is formed on a single semiconductor substrate. Referring to Fig. 22, reference numeral 371 denotes an n-type semiconductor substrate; 381, a p-type semiconductor layer; 382, an n-type semiconductor layer; and 383, a p-type semiconductor layer. Note that the same reference numerals as in Fig. 21 denote the same parts.

The embodiment shown in Fig. 22 is characterized in that the switching elements S, the coupling diodes D₋₂ to D₁ and D₋₂' to D₂', the light-emitting elements L and the like can be formed by a combination of the semiconductor layers 381, 382 and 383 and the semiconductor substrate 371. Therefore, the circuit arrangement shown in Fig. 21 can be integrally formed without complicating the manufacturing steps.

In the switching element S(-2), the uppermost p-type semiconductor layer 381 serves as an anode, the n-type semiconductor layer 382 serves as the gate G₋₂' and the n-type semiconductor substrate 371 serves as a cathode. Two islands of the p-type semiconductor layer 381 formed on the n-type semiconductor layer 382 serve as the coupling diodes D₋₂ and D₋₂'. These diodes D₋₂ and D₋₂' have the same structure as that of the switching element S(-2) and are formed by exactly the same manufacturing steps as those of the switching element S(-2).

The light-emitting element L(-2) has the same structure as that of the switching element S(-2) and is formed by the same manufacturing steps.

The resistors R_{A1} to R_{A3} and R_{L1} to R_{L3} can be formed by using a thin film resistor or by using the semiconductor layers 381, 382 and 383. Although a light-shielding layer is formed on the switching elements S, it is not shown in Fig. 22. According to the structure shown in Fig. 22, the light-emitting device can perform exactly the same operation as described above with reference to Fig. 21.

In the structure shown in Fig. 22, a device having a mode utilizing natural light emission is exemplified as a light-emitting element. The device can operate without any problem by a mode using induction emission (i.e., a laser mode).

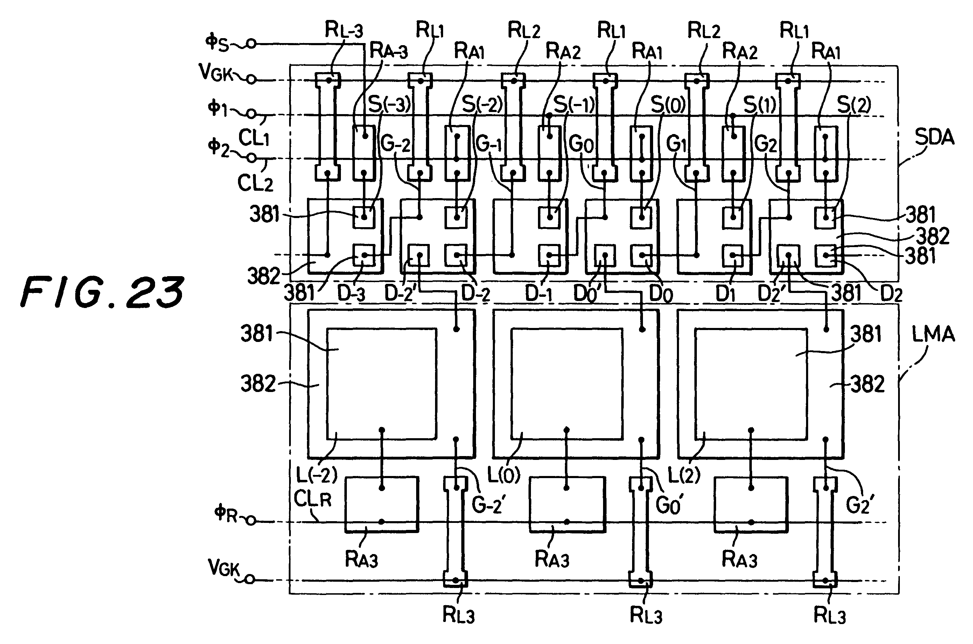

Fig. 23 is a plan view showing a planar structure of Fig. 22. In Fig. 23, the same reference numerals as in Figs. 21 and 22 denote the same parts. As shown in Fig. 23, the switching element array SDA and the light-emitting element array LMA are separately arranged in upper and lower portions. The resistors R_{A1} to R_{A3} and R_{L1} to R_{L3} are formed by a thin film resistor (the resistors can also be formed by using the semiconductor layers 381 to 383).

Although a light-shielding layer for shielding vias light is formed on the switching elements S, it is not shown in Fig. 23.

Referring to Fig. 23, one light-emitting element L is provided for two switching elements S, and a pitch of the light-emitting elements L is twice that of the switching elements S. Therefore, in order not to decrease an integration degree, the switching elements are arranged in two lines in a zig-zag manner. Alternatively, the pitch of the light-emitting elements L can be decreased by forming another switching element array SDA at the opposite side of the light-emitting element array LMA.

In the above first to fourth embodiments, the semiconductor layers are stacked to form a pnpn structure from the upper portion. However, an npnp structure can similarly operate by inverting the polarities of an operation voltage, transfer clocks and the like.

In the above first to fourth embodiments, the pnpn thyristor arrangement is exemplified as a portion having a shift register function. However, an arrangement in which information transfer operation is performed by successive propagation of change in turn-on threshold level is not particularly limited as long as the arrangement can perform this function. For example, exactly the same shift register function can be achieved by using not the pnpn 4-layer arrangement but an arrangement having six or more layers.

In the first to fourth embodiments, the pnpn thyristor arrangement is exemplified. However, the same function can be achieved by using a static induction (SI) thyristor or a field-controlled thyristor (FCT).

In the above first to fourth embodiments, the grounded semiconductor substrate is used. However, the present invention is not limited to this, but another substance can be used as a substrate. For example, an n-type GaAs layer may be formed on a semi-insulating GaAs substrate doped with, e.g., chromium (Cr), and the structure of the first to fourth embodiments may be formed on this layer. Alternatively, a semiconductor film may be formed on an insulating substrate consisting of, e.g., glass or aluminum, and the structure of the first to fourth embodiments may be formed by using this semiconductor film.

As described above, in the light-emitting device of the fourth embodiment, a previously proposed self-scanning light-emitting device is used as a transfer switching array, and a light emission function is isolated to another light-emitting element array having substantially the same structure. Therefore, a light-shielding layer can be formed on the switching elements for transferring an ON state which causes bias light, thereby eliminating an influence of the bias light on an image information write operation. As a result, when the light-emitting device is applied to an optical printer or the like, the quality of the optical printer or the like can be improved.

In addition, a signal for writing image information is not supplied to a clock line as in a previously proposed technique but can be directly input in common with a start pulse to the switching elements. Therefore, the arrangement of a driver can be simplified to reduce manufacturing cost.

Furthermore, since information written in the light-emitting element can be maintained until the element is reset by a scanning signal (clock φ_{R}), a duty cycle of light emission can be set to be substantially 1. Therefore, a current amount (peak value) to be flowed to the light-emitting element can be reduced to realize a long life of the light-emitting device.

Note that the light-emitting device having a light emission duty cycle of substantially 1 can be realized by comparatively simple manufacturing steps by forming a light-emitting element array.

The light-emitting device of the fourth embodiment can be applied to a display or the like. In this case, the performance of such equipment can be largely improved and its manufacturing cost can be largely reduced.

### <Embodiment 5>

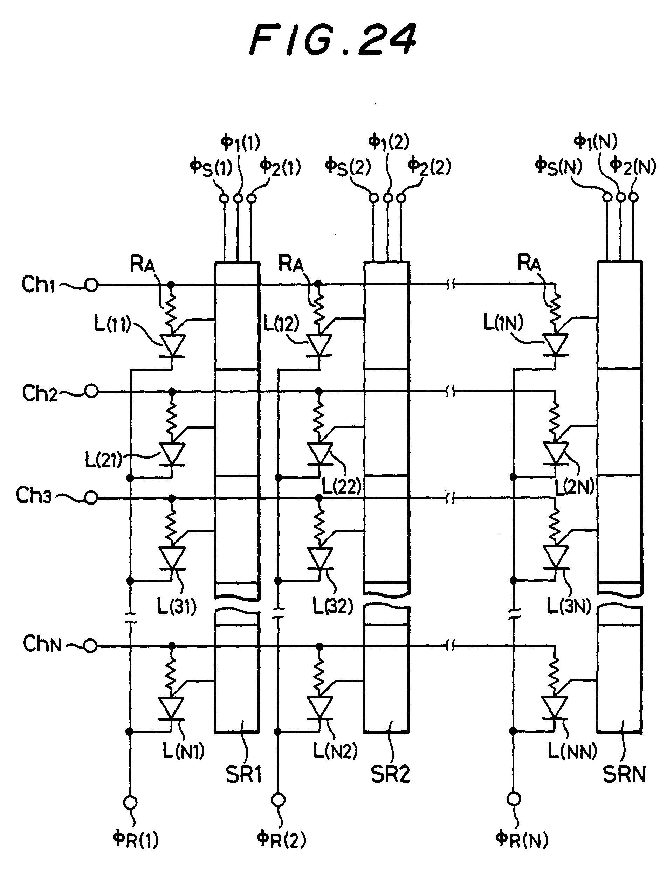

Fig. 24 is a circuit diagram showing the fifth embodiment of the present invention, in which the present invention is applied to an optical switching system. Referring to Fig. 24, reference symbols Ch1 to ChN denote channel numbers at a transmission side; φ_{S}(1) to φ_{S}(N), start pulses of switching element arrays SR1 to SRN capable of sequentially, selectively transferring an ON state of a switching element to another switching element; φ₁(1) to φ₁(N) and φ₂(1) to φ₂(N), transfer clocks; L(11) to L(NN), codes of light-emitting memory elements; R_{A}, a current limiting resistor of each of the light-emitting memory elements L(11) to L(NN); and φ_{R}(1) to φ_{R}(N), reset pulses of the light-emitting memory elements.

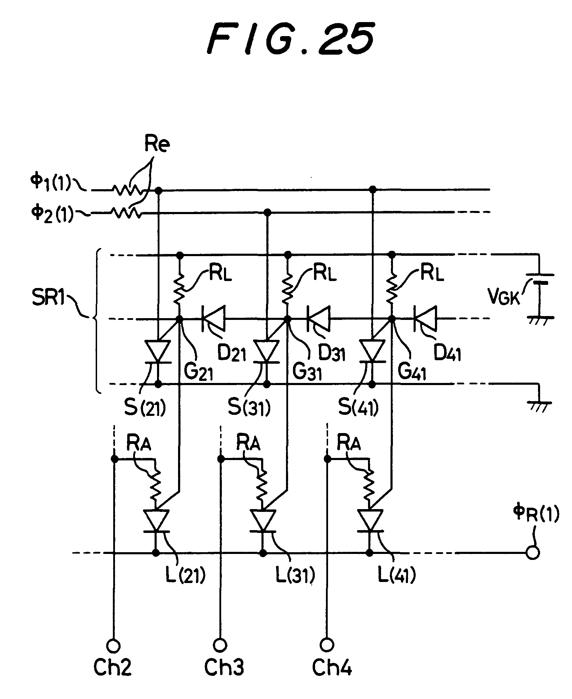

Fig. 25 is an equivalent circuit diagram of the light-emitting memory elements L(21), L(31) and L(41) and the corresponding switching element array SR1. The switching element array SR1 shown in Fig. 25 is obtained by connecting the adjacent switching elements S(21) to S(41) by diodes D₂₁ to D₄₁. The switching array SR1 performs a shift register operation by using two transfer clocks φ₁ and φ₂. The gate voltage of each of the switching elements S(21) to S(41) is used as an output from the switching element array SR1. Note that the switching elements S(21) to S(41) may be connected by the resistors R_{I} instead of the diodes D₂₁ to D₄₁ as shown in Fig. 6.

When the switching element S(31) (each switching element is a thyristor) is turned on by the start pulse φ_{S1} (Fig. 24), a gate potential G₃₁ is set at substantially 0 V. Since a gate potential G₂₁ of the switching element S(21) connected via the diode D₂₁ is in a reverse direction of the diode, a power source voltage V_{GK} (5 V) is applied as the potential by the resistor R_{L}. The gate G₄₁ connected via the diode D₃₁ is set at a voltage higher by a forward rise voltage V_{dif} (about 1 V) of the diode, i.e., about 1 V. For this reason, the gate voltages of the light-emitting memory elements L(21), L(31) and L(41) (each element is basically a thyristor) are set at 5 V, 0 V and 1 V corresponding to the voltages of the gates G₂₁, G₃₁ and G₄₁ of the switching elements S(21), S(31) and S(41), respectively. If the potential of the reset pulse φ_{R}(1) of the light-emitting memory elements is set at 0 V, turn-on voltages of the light-emitting memory elements L(21), L(31) and L(41) are set at values higher than the respective gate potentials by V_{dif}, i.e., about 6 V, 1 V and 2 V, respectively. Therefore, by setting a DC voltage of Ch2 to Ch4 between 1 V and 2V, only the light-emitting memory element V(31) corresponding to the switching element S(31) which is turned on in the switching element array SR1 is turned on. At this time, a current of the light-emitting memory element is limited by the resistor R_{A}. A light emission intensity of the light-emitting memory element L(31) is changed by a modulation signal superposed on the DC voltage of Ch3, and this changed light emission intensity is extracted as a light signal output.

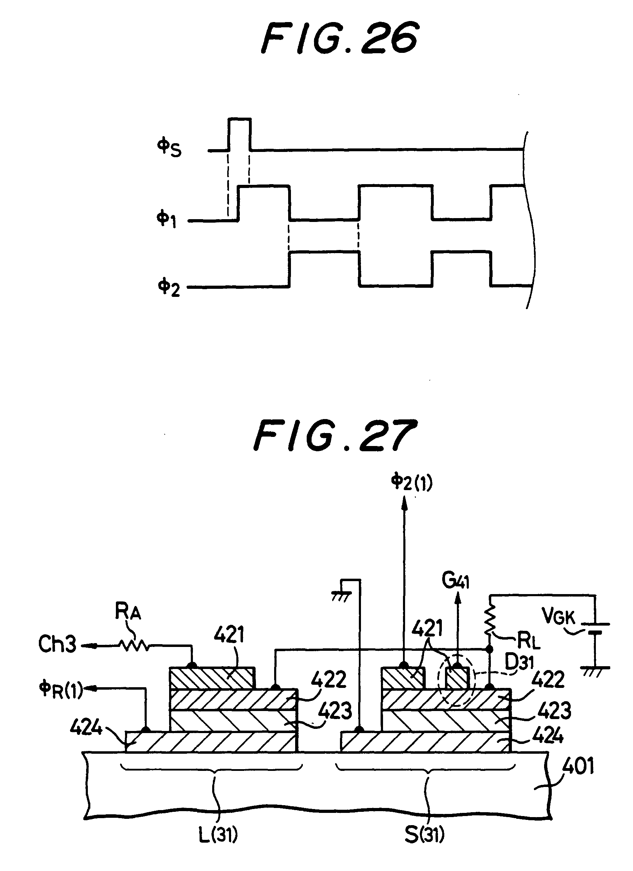

In order to switch the channels, the potential of the reset pulse φ_{R}(1) of the light-emitting memory element is increased to be 2 V or more or the current is cut, thereby turning off the light-emitting memory element in an ON state. Thereafter, the transfer clocks φ₁ and φ₂ (the start pulse = 2 V) shown in Fig. 26 are applied to the signal line to turn off the switching element S(31) and turn on the switching element S(41). In this manner, this ON state can be sequentially transferred to a selected switching element S(n1) in accordance with the number of pulses of the transfer clock. Thereafter, when the voltage of the reset pulse φ_{R}(1) of the light-emitting memory element is set at 0 V again, a light-emitting memory element corresponding to the switching element S(n1) to which the ON state is transferred is turned on, i.e., a light signal of the channel Chn can be extracted.

The above channel selection and switching can be independently performed for each switching element array SR1. Therefore, the N switching element arrays SR1 to SRN can be entirely independently operated.

Fig. 27 is a partial sectional view showing the equivalent circuit shown in Fig. 25. Referring to Fig. 27, reference numeral 401 denotes an insulating GaAs substrate; 424, an n-type epitaxial layer grown on the GaAs substrate 401 by an MOVPE method or the like; 423, a p-type epitaxial layer; 422, an n-type epitaxial layer; and 421, a p-type epitaxial layer. These layers 421, 422, 423 and 424 form a pnpn thyristor structure. After formation of the layers, the structure shown in Fig. 27 is formed by a method such as photoetching. A structure at the right side in Fig. 27 corresponds to the switching element L(31), and that at the left side corresponds to the light-emitting memory element L(31). A coupling diode at the switching element array side is formed by using the layers 421 and 422 of the switching element S(31). A wiring for connecting these elements is formed of a metal such as aluminum or gold, and the resistors R_{L} and R_{A} are formed by using, e.g., a mixture of Cr and SiO. As is apparent from Fig. 27, since the light-emitting memory element and the thyristor, the diode and the like for the switching element can be formed on the same substrate, a light-emitting memory element can be formed with high reliability at low cost.

In this embodiment, a thyristor structure is exemplified as the light-emitting memory element and a basic constituting element of the shift register. However, the present invention is not limited to this structure. For example, exactly the same function can be obtained by a pnpnpn structure constituted by three p-n structures, and the device similarly operates with four or more p-n structures.

In this embodiment, in place of the pnpn thyristor structure, an element called a static induction thyristor (FCT: Field-Controlled Thyristor, S.M.Sze, Physics of Semiconductor Devices, 2nd edition, pp. 238 to 240) in which a depletion layer is used instead of an internal p- or n-type semiconductor layer to obtain substantially the same switching characteristics as those of a thyristor can be used.

Although a GaAs substrate is used in this embodiment, another substrate such as an InP or ZnSe substrate can be used to change a light emission wavelength. That is, this embodiment is not limited to materials to be used.

### <Applications>

A switching system is a necessary device in order to arbitrarily select a channel between a plurality of transmitters and a plurality of receivers. An electric switching system has, however, a complicated wiring, and the wiring serves as an antenna at an RF frequency to produce crosstalk. In recent years, therefore, a switching system using light has attracted attention.

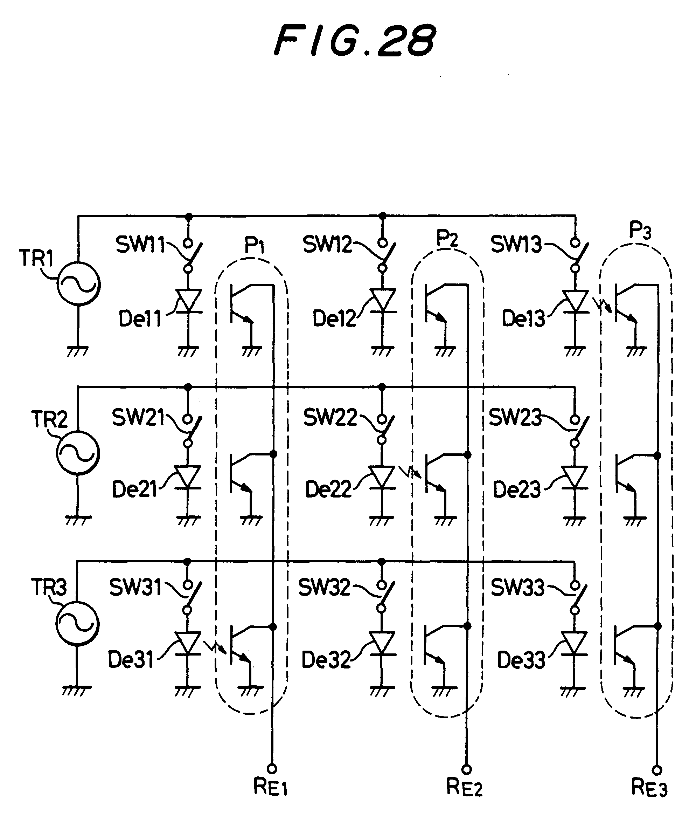

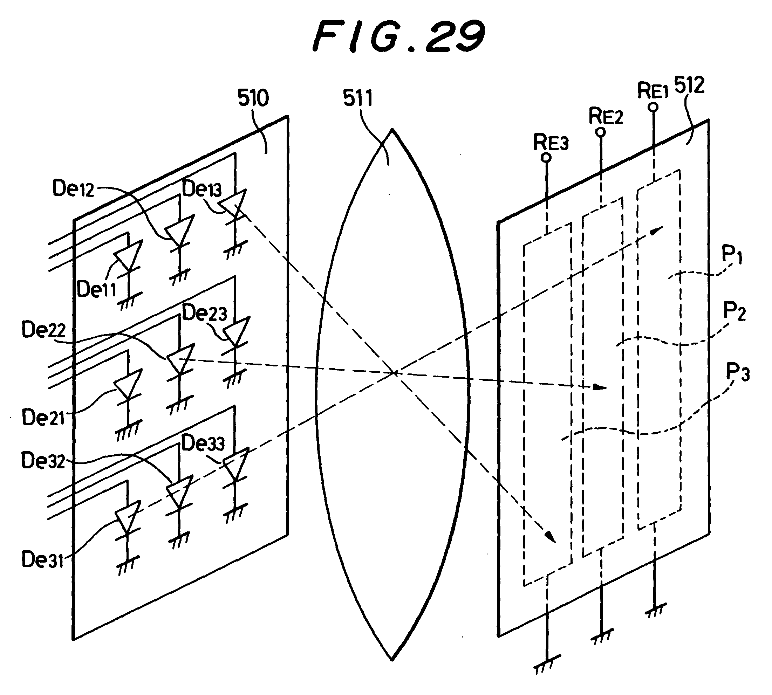

Figs. 28 and 29 show a conventional arrangement of such an optical switching system. Figs. 28 and 29 show a simplest arrangement of a switching system for three transmitters x three receivers in order to explain an operation principle. Referring to Figs. 28 and 29, reference symbols TR1, TR2 and TR3 denote transmitters; RE1, RE2 and RE3, receivers; De11 to De33, light-emitting diodes; and P1, P2 and P3, light-receiving transistors. The light-emitting diodes are selected by switches SW11 to SW33. In Fig. 29, reference numeral 510 denotes a light-emitting diode array; 511, a lens; and 512, a light-receiving transistor array. The light-emitting diodes are arranged in one-to-one correspondence with light-receiving positions.

As one function required for this optical switching system, a receiver must independently select a desired transmitter. In Fig. 28, this function can be achieved by independently select the switches SW11 to SW33.

It is, however, difficult to form the switches SW11 to SW33 and the light-emitting diodes on the same substrate. For this reason, another switching element array is formed close to the light-emitting diodes and connected to the diodes by a technique such as bonding, or terminals of the light-emitting diodes are extracted outside to be electrically connected. In the former arrangement, not only an area of the light-emitting diode array is increased but also assembly cost is increased. In the latter arrangement, since an amount of wiring to be extracted outside is increased as the number of light-emitting elements is increased, practical numbers of the light-emitting elements and the channels are limited.

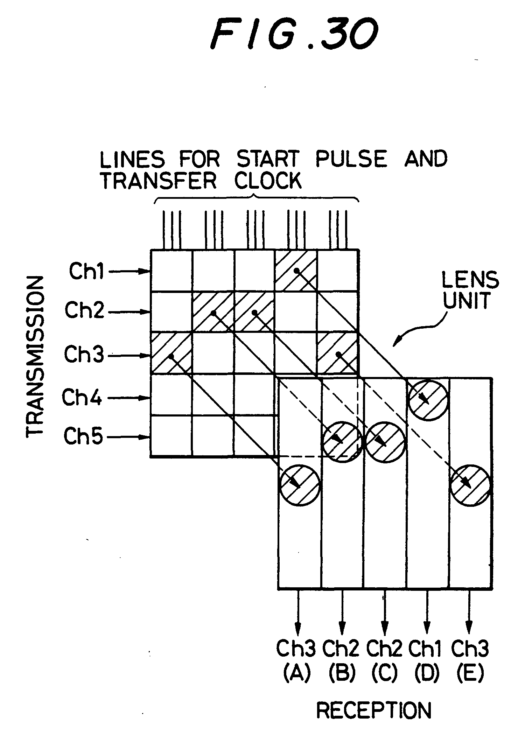

In order to eliminate the above drawbacks, the above fifth embodiment can be applied. This application is shown in Fig. 30.

Fig. 30 shows an arrangement of this application having a combination of a light-emitting memory element array and a photodiode array as a light-receiving element array. In this arrangement, the number of channels is five. Signals are transmitted from a transmitter side through channels Ch1 to Ch5, and the number of receivers is five, A to E. Although the numbers of transmitters and receivers are the same in this arrangement, the numbers may be different. A lens system is not shown in Fig. 30, but it is arranged to focus the light output from the transmitter side onto a corresponding position of the receiver side. The receivers independently select desired channels. Selection from the channels Ch1 to Ch5 is performed by using a transfer clock applied to the switching element arrays SR1 to SR5 as described above. As shown in Fig. 30, a plurality of receivers can select the same channel.

The arrangement of this application requires the same number of switching element arrays as that of receivers and the same number of channels as that of transmitters. Therefore, the number of signal lines including a power source line and a ground (GND) line required for the light-emitting memory array of this application is:$\text{the number of transmitters + the number of} \text{receivers x (3 + 1) + 2}$ That is, a required number of signal lines at the transmitter side is the number of transmitters, and lines at the receiver side are a start pulse line, two transfer clock lines, and a reset pulse line of the light-emitting memory element per receiver. In addition, a power source line and a ground line are required. The number of signal lines required for the conventional light-emitting element array shown in Figs. 28 and 29 is:$\text{the number of transmitters x the number of} \text{receivers + 1}$ because all the terminals of the light-emitting diodes must be extracted outside.

Assuming that the number of transmitters is 10 and the number of receivers is 10, the numbers of signal lines are:
This application = 52
The conventional arrangement = 101
That is, the number of signal lines of this application is about half that of the conventional arrangement. This difference is increased as the number of channels is increased. Therefore, the light-emitting memory array according to this application has an effect in a large amount of signal switching.

Note that the application of the fifth embodiment is not limited to the combination of a light-emitting element array and a light-receiving element array. For example, the fifth embodiment can be applied to an arrangement in which an output from a light-emitting memory element is supplied to an optical fiber or the like.

## Claims

1. A light-emitting device comprising:
a plurality of light-emitting cells aligned along a row direction, each said light-emitting cell comprising a negative resistance switching element (S(-1), S(0), S(1)) having a current electrode and a control electrode and when operating in an on state said control electrode and said current electrode having substantially the same potential,
coupling means (D₋₁, Dₒ, D₁) connected between said control electrodes of one cell and the next cell, and one or more light-emitting elements (L(-1), L(0), L(1)) each having a control electrode and a current electrode and when operating in an on state said control electrode and said current electrode having substantially the same potential, the control electrodes of the switching element (S(-1), S(0), S(1)) and the light emitting element(s) (L(-1), L(0), L(0)) being connected in common;
at least two transfer clock lines (∅₁, ∅₂) connected to said current electrode of said switching elements in a sequential alternating manner, said switching elements being arranged to provide a self-scanning function in response to drive pulses from a drive means which are applied to the respective transfer clock lines in a sequential alternating manner;
a signal line (Sin) connected to said current electrode of said light-emitting element(s) for receiving a light emission control current for light emission thereof; and
a plurality of load resistance means (R_{L}) each connected between the control electrode of a respective switching element and a bias line (V_{GK}).

2. A device according to claim 1, wherein a binary current supply means corresponding to light emission/non-light emission is connected to said signal line.

3. A device according to claim 1, wherein an analog current supply means for controlling the luminance of light emission by an analog value is connected to said signal line.

4. A device according to claim 1, claim 2 or claim 3, wherein said light-emitting element (L(-1), L(0), L(1)) of each said cell comprises a 3-terminal thyristor in which a plurality of p- and n-type semiconductor regions are stacked, said current electrode being an anode, and said control electrode is a gate.

5. A device according to claim 4, wherein said switching element (S(-1), S(0), S(1)) of said each cell comprises a 3-terminal thyristor in which a plurality of p- and n-type semiconductor regions are stacked, and on which a light-shielding layer for shielding light radiation is formed.

6. A device according to claim 1, comprising current supply means for supplying the light emission current to the current electrodes of said light-emitting elements (L(-1), L(0), L(1)) in synchronism with a turn-on transfer timing of said switching element as driven by said drive means.

7. A device according to claim 6, wherein said current supply means is arranged to include a turn-off pulse in the light emission current which has an effect of biasing each light-emitting element in an OFF state after said light-emitting element emits light in synchronism with turn-on transfer of said switching means.

8. A device according to claim 5, wherein said coupling means (D₋₁, Dₒ, D₁) has uni-directivity for regulating the change in threshold level to one direction of the aligned cells.

9. A device according to any one of claims 1 to 7, wherein said coupling means comprises a resistor (R₁).

10. A device according to any one of claims 1 to 8, wherein said coupling means comprises a diode (D₋₁, D₀, D₁).

11. A device according to claim 1, wherein said switching elements further comprise a start switching element having a control electrode connected to said control electrode of said switching element via said coupling means, an anode for receiving a start signal (∅s), and a load resistance means (R_{L}) connected between said control electrode and said bias line (V_{GK}).

12. A device according to any one of claims 1 to 11, wherein each light emitting cell comprises a light-emitting block (L₁(-1), L₂(-1), L₃(-1); L₁(0), L₂(0), L₃(0)) having a plurality of light-emitting elements each of which has a control electrode and a current electrode, the control electrodes of each block being connected in common and to the control electrode of the respective switching element, a plurality of signal lines (Sin1, Sin2, Sin3) being connected to the current electrodes of respective light-emitting elements in each block.

13. A device according to claim 1, wherein for each said light-emitting cell:
said switching element comprises an odd and an even switching element (S(-3), S(-2), S(-1), 3(0)),
said coupling means comprises odd and even coupling means (D₋₃, D₋₂, D₋₁, D₀) for said control electrodes of the respective odd and even switching elements; and
said light-emitting element (L(-2), L(0), L(2)) is isolated from said switching elements and has a control electrode operatively connected to the control electrode of the even switching element via another coupling means (D₋₂', D₀', D₂').

14. A device according to claim 12, further comprising:
a write array of write switching elements (Tᵣ₃(1), Tᵣ₃(2), Tᵣ₃(3)) each connected between an image signal line and said control electrode of said light-emitting element and turning on under control of said first-mentioned switching element; and
a reset array of reset switching elements (Tᵣ₄(1), Tᵣ₄(2), Tᵣ₄(3)) each connected between a reset line and said current electrode of said light-emitting element and turning on under control of said first-mentioned switching element.

15. A device according to claim 1, further comprising a write array of write switching elements (Tᵣ₃(1), Tᵣ₃(2), Tᵣ₃(3)) having a number corresponding to that of said first-mentioned switching elements (S(-1), S(0), S(1)) wherein said write switching element is energized in response to a turn-on signal from said first-mentioned switching element at the same column to supply an image signal to the control electrode of said light-emitting element at the same column to turn on said light-emitting element which maintains an on-state itself.

16. A device according to claim 15, further comprising a reset array having a line of reset switching elements (Tᵣ₄(-1), Tᵣ₄(2), Tᵣ₄(3)) adjacent to said first-mentioned switching elements, wherein said reset switching elements are energized in response to said turn-on signal from said first-mentioned switching element at the same column to supply a turn-off reset signal to said current electrode of said light-emitting element at the next column.

17. A device according to claim 14, 15 or 16, wherein said reset switching element is a transistor.

18. A device according to claim 1, further comprising a plurality of rows extending along a column direction to form a plurality of columns and each row having one of said plurality of said light-emitting elements L(NN), where N is a positive integer, for each of said plurality of columns;
a plurality of write signal channel lines Ch(N) each said channel line Ch(N) being connected to said current electrodes of said light-emitting elements L(N1) to L(NN) of a respective row; and
a plurality of reset lines ((∅_{R}(N)) each being connected to further current electrodes of said light-emitting elements L(1N) to L(NN) of a respective column.

19. A device according to claim 18, comprising a plurality of light receiving sensors which are arranged opposite said plurality of light emitting elements (De 11, De 33) so that light from at least one of said light emitting elements (De 11, De 33) is received by at least one of said light receiving sensors, wherein said write signal channel lines (Ch(W)) constitute a plurality of transmission channels (Ch1, Ch5), and said light receiving sensors correspond to a plurality of reception channels.

20. A device according to claim 19, wherein the numbers of said transmission channels (Ch1, Ch5) and said reception channels are the same.

## Patentansprüche

1. Lichtemittierende Vorrichtung, die aufweist:
eine Mehrzahl von lichtemittierenden Zellen, die entlang einer Spaltenrichtung angeordnet sind, wobei jede lichtemittierende Zelle ein Negativwiderstandsschaltelement (S(-1), S(0), S(1)) aufweist mit einer Stromelektrode und einer Steuerelektrode und wobei die Steuerelektrode und die Stromelektrode im wesentlichen das gleiche Potential haben, wenn sie in einem "Ein"-Zustand betrieben werden,
eine Kopplungseinrichtung (D₋₁, D₀, D₁), die zwischen den Steuerelektroden einer Zelle und
der nächsten Zelle angeschlossen sind, und ein oder mehrere lichtemittierende Elemente (L(-1), L(0), L(1)) mit jeweils einer Steuerelektrode und einer Stromelektrode, wobei die Steuerelektrode und die Stromelektrode im wesentlichen das gleiche Potential haben, wenn sie in einem "Ein"-Zustand betrieben werden, wobei die Steuerelektroden des Schaltelements (S(-1), S(0), S(1)) und das (die) emittierende(n) Element(e) (L(-1), L(0), L(1)) gemeinsam angeschlossen sind,
zumindest zwei Übertragungstaktleitungen (Ø₁, Ø₂), die mit den Steueretektroden der Schaltelemente in einer sequentiell altemierenden Art und Weise verbunden sind, wobei die Schaltelemente derart angeordnet sind, daß sie eine selbstabfragende Funktion in Antwort auf Antriebspulse von einer Antriebsvorrichtung zur Verfügung stellen, die an den jeweiligen Übertragungstaktleitungen in einer sequentiell alternierenden Art und Weise angelegt werden,
eine Signalleitung (Sin), die mit der Steuerelektrode des (der) lichtemittierenden Elements(e) verbunden ist, für das Empfangen eines Lichtemissionssteuerstroms für deren Lichtemission, und
eine Mehrzahl von Belastungswiderstandsvorrichtungen (R_{L}), die jeweils zwischen der Steuerelektrode eines entsprechenden Schaltelements und einer Bias-Leitung (V_{GK}) angeschlossen ist.

2. Vorrichtung nach Anspruch 1, in der eine binäre Stromzuführungsvorrichtung, entsprechend der "Lichtemission"/"Nicht-Lichtemission", mit der Signälleitung verbunden ist.

3. Vorrichtung nach Anspruch 1, in der eine analoge Stromzuführungsvorrichtung für die Steuerung der Leuchtdichte der Lichtemission durch einen analogen Wert mit der Signalleitung verbunden ist.

4. Vorrichtung nach Anspruch 1, Anspruch 2 oder Anspruch 3, in der das lichtemittierende Element (L(-1), L(0), L(1)) jeder Zelle einen 3-Anschluß-Thyristor aufweist, in dem eine Mehrzahl von p- und n-Typ-Halbleiterregionen übereinander angeordnet sind, wobei die Stromelektrode eine Anode ist und die Steuerelektrode ein Gate ist.

5. Vorrichtung nach Anspruch 4, wobei das Schaltelement (S(-1), S(0), S(1)) von jeder Zelle einen 3-Anschluß-Thyristor aufweist, in dem eine Mehrzahl von p- und n-Typ-Haibleiterregionen übereinander angeordnet sind, und auf denen eine lichtabschirmende Schicht für das Abschirmen von Lichtstrahlung ausgebildet ist.

6. Vorrichtung nach Anspruch 1, die eine Stromzuführungsvorrichtung für das Zuführen des Lichtemissionsstroms zu den Stromelektroden der lichtemittierenden Elemente (L(-1), L(0), L(1)) zugleich mit einer Anschaltübertragungssynchronisierung des Schaltelements aufweist, wie es von der Antriebsvorrichtung gesteuert wird.

7. Vorrichtung nach Anspruch 6, wobei die Stromzuführungsvorrichtung derart ausgelegt ist, daß in dem Lichtemissionsstrom ein Ausschaltpuls enthalten ist, was den Effekt hat, daß jedes lichtemittierende Element in einem "Aus"-Zustand vorgespannt wird, nachdem das lichtemittierende Element synchron zu der "Anschalt"-Übertragung der Schaltvorrichtung Licht emittiert.

8. Vorrichtung nach Anspruch 5, wobei die Kopplungsvorrichtung (D₋₁, D₀, D₁) eine Richtwirkung in eine Richtung hat für die Regulierung der Veränderung des Grenzwertniveaus in einer Richtung der angeordneten Zellen.

9. Vorrichtung nach einem der Ansprüche 1 bis 7, wobei die Kopplungsvorrichtung einen Widerstand (R₁) aufweist.

10. Vorrichtung nach einem der Ansprüche 1 bis 8, wobei die Kopplungsvorrichtung eine Diode (D₋₁, D₀, D₁) aufweist.

11. Vorrichtung nach Anspruch 1, wobei die Schaltelemente weiterhin ein Startschaltelement mit einer Steuerelektrode, die mit der Steuerelektrode des Schaltelements über die Kopplungsvorrichtung verbunden ist, eine Anode für das Empfangen eines Startsignals (Øs) und eine Belastungswiderstandsvorrichtung (R_{L}) aufweist, die zwischen die Steuerelektrode und die Vorspannungsleitung (V_{GK}) geschaltet ist.

12. Vorrichtung nach einem der Ansprüche 1 bis 10, wobei jede lichtemittierende Zelle einen lichtemittierenden Block (L₁(-1), L₂(-1), L₃(-1); L₁(0), L₂(0), L₃(0)) mit einer Mehrzahl von lichtemittierenden Elementen aufweist, die jeweils eine Steuerelektrode und eine Stromelektrode haben, wobei die Steuerelektroden von jedem Block gemeinsam an der Steuerelektrode des jeweiligen Schaltelements angeschlossen sind, und eine Mehrzahl von Signalleitungen (Sin1, Sin2, Sin3) aufweist, die mit den Stromelektroden der jeweiligen lichtemittierenden Elemente in jedem Block verbunden sind.

13. Vorrichtung nach Anspruch 1, wobei für jede lichtemittierende Zelle:
das Schaltelement ein gerades und ein ungerades Schaltelement (S(-3), S(-2), S(-1), S(0)) aufweist,
die Kopplungsvorrichtung gerade und ungerade Kopplungseinrichtungen (D₋₃, D₋₂, D₋₁, D₀) für die Steuerelektroden der jeweiligen geraden und ungeraden Schaltelemente aufweist, und
das lichtemittierende Element (L(-2), L(0), L(2)) von den Schaltelementen isoliert ist und eine Steuerelektrode hat, die wirksam mit der Steuerelektrode des geraden Schaltelements über eine andere Kopplungseinrichtung (D₋₂', D₀', D₂') verbunden ist.

14. Vorrichtung nach Anspruch 12, die weiterhin aufweist:
ein Schreibarray von Schreibschaltelementen (Tᵣ₃(1), Tᵣ₃(2), Tᵣ₃(3)), die jeweils zwischen einer Bildsignalleitung und der Steuerelektrode des lichtemittierenden Elements angeschlossen sind und sich unter Steuerung des zuerst erwähnten Schaltelements anschalten, und
eine Rückstellanordnung von Rückstellschaltelementen (Tᵣ₄(1), Tᵣ₄(2), Tᵣ₄(3)), die jeweils zwischen einer Rückstelleitung und der Stromelektrode des lichtemittierenden Elements angeschlossen sind und sich unter Steuerung des ersterwähnten Schaltelements anschalten.

15. Vorrichtung nach Anspruch 1, die weiterhin eine Schreibanordnung von Schreibschaltelementen (Tᵣ₃(1), Tᵣ₃(2), Tᵣ₃(3)) in einer Anzahl aufweist, die zu den zuerst erwähnten Schaltelementen (S(-1), S(0), S(1)) korrespondiert, wobei das Schreibschaltelement in Antwort auf ein Anschaltsignal von dem zuerst erwähnten Schaltelement in der gleichen Spalte angeregt wird, um ein Bildsignal zu der Steuerelektrode des lichtemittierenden Elements in der gleichen Spalte zu liefern, um das lichtemittierende Element anzuschalten, wobei es selbst einen "An"-Zustand beibehält.

16. Vorrichtung nach Anspruch 15, die weiterhin eine Rückstellanordnung aufweist mit einer Zeile von Rückstellschaltelementen (Tᵣ₄(-1), Tᵣ₄(2), Tᵣ₄(3)), die zu den zuerst erwähnten Schaltelementen benachbart sind, wobei die Rückstellschaltelemente in Antwort auf das Anschaltsignal von dem zuerst erwähnten Schaltelement in der gleichen Spalte erregt werden, um ein Abschaltrückstellsignal zu der Stromelektrode des lichtemittierenden Elements in der nächsten Spalte zu liefern.

17. Vorrichtung nach Anspruch 14, 15 oder 16, wobei das Rückstellschaltelement ein Transistor ist.

18. Vorrichtung nach Anspruch 1, die weiterhin eine Mehrzahl von Zeilen aufweist, die sich entlang einer Spaltenrichtung erstrecken, um eine Mehrzahl von Spalten zu bilden, wobei jede Zeile eines der Mehrzahl von lichtemittierenden Elementen L(NN) hat, wobei N eine positive ganze Zahl für jede der Mehrzahl von Spalten ist,
eine Mehrzahl von Schreibsignalkanalleitungen Ch(N) aufweist, wobei jede Kanalleitung Ch(N) mit den Stromelektroden der lichtemittierenden Elemente L(N1) bis L(NN) der entsprechenden Zeile verbunden ist, und
eine Mehrzahl von Rückstelleitungen ((Ø_{R}(N)) aufweist, die jeweils mit weiteren Stromelektroden der lichtemittierenden Elemente L(1N) bis L(NN) der jeweiligen Spalte verbunden sind.

19. Vorrichtung nach Anspruch 18, die eine Mehrzahl von lichtaufnehmenden Sensoren aufweist, die der Mehrzahl der lichtemittierenden Elemente (De 11, De 33) gegenüberliegend angeordnet sind, so daß Licht von zumindest einem der lichtemittierenden Elemente (De 11, De 33) von zumindest einem der lichtempfangenden Sensoren empfangen wird, wobei die Schreibsignalkanalleitungen (Ch(W)) eine Mehrzahl von Übertragungskanälen (Ch1, Ch5) bilden und die lichtempfangenden Sensoren einer Mehrzahl von Empfangskanälen entsprechen.

20. Vorrichtung nach Anspruch 19, wobei die Anzahl der Übertragungskanäle (Ch1, Ch5) und der Empfangskanäle gleich ist.

## Revendications

1. Dispositif d'émission de lumière comportant:
une pluralité de cellules d'émission de lumière alignées suivant une direction d'une rangée, chacune desdites cellules d'émission de lumière comportant un élément de commutation à résistance négative (S(-1), S(0), S(1)) ayant une électrode de courant et une électrode de commande et, lorsqu'il fonctionne dans un état activé, ladite électrode de commande et ladite électrode de courant ayant sensiblement le même potentiel,
un moyen de couplage (D₋₁, D₀, D₁) connecté entre lesdites électrodes de commande d'une cellule et de la cellule suivante, et un ou plusieurs éléments d'émission de lumière (L(-1), L(0), L(1)) ayant chacun une électrode de commande et une électrode de courant et, lorsqu'il fonctionne dans un état activé, ladite électrode de commande et ladite électrode de courant ayant sensiblement le même potentiel, les électrodes de commande de l'élément de commutation (S(-1), S(0), S(1)) et de l'élément ou des éléments d'émission de lumière (L(-1), L(0), L(0)) étant connectées en commun;
au moins deux lignes d'horloge de transfert (Ø₁, Ø₂) connectées à ladite électrode de courant desdits éléments de commutation d'une manière séquentielle alternante, lesdits éléments de commutation étant agencés de façon à produire une fonction d'auto-balayage en réponse à des impulsions d'attaque provenant d'un moyen d'attaque, qui sont appliquées aux lignes d'horloge de transfert respectives d'une manière alternante séquentielle;
une ligne de signal (Sin) connectée à ladite électrode de courant dudit élément ou desdits éléments d'émission de lumière pour la réception d'un courant d'émission de lumière(s) afin que de la lumière en soit émise; et
une pluralité de moyens à résistances de charge (R_{L}) connectés chacun entre l'électrode de commande d'un élément de commutation respectif et une ligne de polarisation (V_{GK}).

2. Dispositif selon la revendication 1, dans lequel un moyen d'alimentation en courant binaire correspondant à des états émission de lumière/non émission de lumière est connecté à ladite ligne de signal.

3. Dispositif selon la revendication 1, dans lequel un moyen d'alimentation en courant analogique destiné à régler la luminance d'une émission de lumière au moyen d'une valeur analogique est connecté à ladite ligne de signal.

4. Dispositif selon la revendication 1, la revendication 2 ou la revendication 3, dans lequel ledit élément d'émission de lumière (L(-1), L(0), L(1)) de chacune desdites cellules comprend un thyristor à trois bornes dans lequel une pluralité de régions en semi-conducteurs de type p et de type n sont empilées, ladite électrode de courant étant une anode, et ladite électrode de commande étant une gâchette.

5. Dispositif selon la revendication 4, dans lequel ledit élément de commutation (S(-1), S(0), S(1)) de chacune desdites cellules comprend un thyristor à trois bornes dans lequel plusieurs régions en semi-conducteurs de type p et de type n sont empilées, et sur lequel est formée une couche formant écran à la lumière, destinée à protéger d'un rayonnement lumineux.

6. Dispositif selon la revendication 1, comportant un moyen d'alimentation en courant destiné à fournir le courant d'émission de lumière aux électrodes de courant desdits éléments d'émission de lumière (L(-1), L(0), L(1)) en synchronisme avec un temps de transfert de déblocage dudit élément de commutation lorsqu'il est attaqué par ledit moyen d'attaque.

7. Dispositif selon la revendication 6, dans lequel ledit moyen d'alimentation en courant est agencé de façon à inclure une impulsion de blocage dans le courant d'émission de lumière qui a pour effet de polariser chaque élément d'émission de lumière dans un état désactivé après que ledit élément d'émission de lumière a émis de la lumière en synchronisme avec un transfert de déblocage dudit moyen de commutation.

8. Dispositif selon la revendication 5, dans lequel ledit moyen de couplage (D₋₁, D₀, D₁) est unidirectionnel de façon à réguler la variation du niveau de seuil dans une direction des cellules alignées.

9. Dispositif selon l'une quelconque des revendications 1 à 7, dans lequel ledit moyen de couplage comprend une résistance (R₁).

10. Dispositif selon l'une quelconque des revendications 1 à 8, dans lequel ledit moyen de couplage comprend une diode (D₋₁, D₀, D₁).

11. Dispositif selon la revendication 1, dans lequel lesdits éléments de commutation comprennent en outre un élément de commutation de départ ayant une électrode de commande connectée à ladite électrode de commande dudit élément de commutation par l'intermédiaire dudit moyen de couplage, une anode destinée à recevoir un signal de départ (Øs), et un moyen à résistance de charge (R_{L}) connecté entre ladite électrode de commande et ladite ligne de polarisation (V_{GK}).

12. Dispositif selon l'une quelconque des revendications 1 à 11, dans lequel chaque cellule d'émission de lumière comprend un bloc d'émission de lumière (L₁(-1), L₂(-1), L₃(-1); L₁(0), L₂(0), L₃(0)) ayant une pluralité d'éléments d'émission de lumière comportant chacun une électrode de commande et une électrode de courant, les électrodes de commande de chaque bloc étant connectées en commun et à l'électrode de commande de l'élément de commutation respectif, une pluralité de lignes de signal (Sin1, Sin2, Sin3) étant connectées aux électrodes de courant des éléments d'émission de lumière respectifs dans chaque bloc.

13. Dispositif selon la revendication 1, dans lequel, pour chacune desdites cellules d'émission de lumière:
ledit élément de commutation comporte un élément de commutation impair et un élément de commutation pair (S(-3), S(-2), S(-1), S(0)),
ledit moyen de couplage comporte des moyens de couplage impair et pair (D₋₃, D₋₂, D₋₁, D₀) pour lesdites électrodes de commande desdits éléments de commutation impairs et pairs respectifs; et
ledit élément d'émission de lumière (L(-2), L(0), L(2)) est isolé desdits éléments de commutation et comporte une électrode de commande connectée fonctionnellement à l'électrode de commande de l'élément de commutation pair par l'intermédiaire d'un autre moyen de couplage (D₋₂', D₀', D₂').

14. Dispositif selon la revendication 12, comportant en outre:
un réseau d'écriture d'éléments de commutation d'écriture (Tᵣ₃(1), Tᵣ₃(2), Tᵣ₃(3)) connectés chacun entre une ligne de signal d'image et ladite électrode de commande dudit élément d'émission de lumière et se débloquant sous la commande dudit élément de commutation mentionné en premier; et
un réseau de restauration d'éléments de commutation de restauration (Tᵣ₄(1), Tᵣ₄(2), Tᵣ₄(3)) connectés chacun entre une ligne de restauration et ladite électrode de courant dudit élément d'émission de lumière et se débloquant sous la commande dudit élément de commutation mentionné en premier.

15. Dispositif selon la revendication 1, comportant en outre un groupement d'écriture d'éléments de commutation d'écriture (Tᵣ₃(1), Tᵣ₃(2), Tᵣ₃(3)) ayant un nombre correspondant à celui desdits éléments de commutation (S(-1), S(0), S(1)) mentionnés en premier, dans lequel ledit élément de commutation d'écriture est excité en réponse à un signal de déblocage provenant dudit élément de commutation mentionné en premier à la même colonne pour fournir un signal d'image à l'électrode de commande dudit élément d'émission de lumière à la même colonne afin de débloquer ledit élément d'émission de lumière qui se maintient de lui-même dans un état débloqué.

16. Dispositif selon la revendication 15, comportant en outre un groupement de restauration ayant une ligne d'éléments de commutation de restauration (Tᵣ₄(1), Tᵣ₄(2), Tᵣ₄(3)) adjacents auxdits éléments de commutation mentionnés en premier, dans lequel lesdits éléments de commutation de restauration sont excités en réponse audit signal de déblocage provenant dudit élément de commutation mentionné en premier à la même colonne pour fournir un signal de restauration de blocage à ladite électrode de courant dudit élément d'émission de lumière à la colonne suivante.

17. Dispositif selon la revendication 14, 15 ou 16, dans lequel ledit élément de commutation de restauration est un transistor.

18. Dispositif selon la revendication 1, comportant en outre une pluralité de rangées s'étendant suivant une direction de colonnes pour former une pluralité de colonnes et chaque rangée ayant l'un de ladite pluralité desdits éléments d'émission de lumière L(NN), où N est un entier positif, pour chacune de ladite pluralité de colonnes;
une pluralité de lignes Ch(N) de canaux de signaux d'écriture, chaque ligne Ch(N) de canal étant connectée auxdites électrodes de courant desdits éléments d'émission de lumière L(N1) à L(NN) d'une rangée respective; et
une pluralité de lignes de restauration ((Ø_{R}(N)) connectées chacune à d'autres électrodes de courant desdits éléments d'émission de lumière L(1N) à L(NN) d'une colonne respective.

19. Dispositif selon la revendication 18, comportant une pluralité de capteurs de réception de lumière qui sont agencés de façon à être opposés à ladite pluralité d'éléments d'émission de lumière (De 11, De 33) afin que de la lumière provenant d'au moins l'un desdits éléments d'émission de lumière (De 11, De 33) soit reçue par au moins l'un desdits capteurs de réception de lumière, dans lequel lesdites lignes de canaux de signaux d'écriture (Ch(W)) constituent une pluralité de canaux de transmission (Ch1, Ch5), et lesdits capteurs de réception de lumière correspondent à une pluralité de canaux de réception.

20. Dispositif selon la revendication 19, dans lequel les nombres desdits canaux de transmission (Ch1, Ch5) et desdits canaux de réception sont les mêmes.
